(19) Europäisches Patentamt
European Patent Office
Office européen des brevets

(11) EP 3 605 633 A1

(12) # EUROPEAN PATENT APPLICATION
published in accordance with Art. 153(4) EPC

(43) Date of publication:
**05.02.2020 Bulletin 2020/06**

(21) Application number: **17901824.7**

(22) Date of filing: **24.03.2017**

(51) Int Cl.:
***H01L 51/50*** *(2006.01)*
***C08G 61/12*** *(2006.01)*
***C09D 11/00*** *(2014.01)*
***G09F 9/30*** *(2006.01)*
***H01L 27/32*** *(2006.01)*

(86) International application number:
**PCT/JP2017/012068**

(87) International publication number:
**WO 2018/173265 (27.09.2018 Gazette 2018/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **HITACHI CHEMICAL COMPANY, LTD.**
**Chiyoda-ku**
**Tokyo**
**100-6606 (JP)**

(72) Inventors:
- **HONNA Ryo**
  **Tokyo 100-6606 (JP)**
- **YOSHINARI Yuki**
  **Tokyo 100-6606 (JP)**
- **SUGIOKA Tomotsugu**
  **Tokyo 100-6606 (JP)**
- **ISHITSUKA Kenichi**
  **Tokyo 100-6606 (JP)**
- **SAKUMA Hirotaka**
  **Tokyo 100-6606 (JP)**
- **KAMO Kazuyuki**
  **Tokyo 100-6606 (JP)**
- **RYUZAKI Daisuke**
  **Tokyo 100-6606 (JP)**

(74) Representative: **Beckmann, Claus**
**Kraus & Weisert**
**Patentanwälte PartGmbB**
**Thomas-Wimmer-Ring 15**
**80539 München (DE)**

(54) **ORGANIC ELECTRONIC MATERIAL, INK COMPOSITION, ORGANIC LAYER AND ORGANIC ELECTRONIC ELEMENT**

(57) Disclosed is an organic electronic material containing a polymer or oligomer having a structural unit that has hole transport properties, and also having an alkyl chain of 6 to 20 carbon atoms. Also disclosed are an ink composition, an organic layer, an organic electronic element, an organic electroluminescent element, a display element, an illumination device and a display device.

EP 3 605 633 A1

## Description

TECHNICAL FIELD

Embodiments of the present invention relate to an organic electronic material, an ink composition, an organic layer, an organic electronic element, an organic electroluminescent element (also referred to as an "organic EL element"), a display element, an illumination device, and a display device.

BACKGROUND ART

Organic EL elements are attracting attention for potential use in large-surface area solid state lighting applications to replace incandescent lamps and gas-filled lamps and the like. Further, organic EL elements are also attracting attention as the leading self-luminous display for replacing liquid crystal displays (LCD) in the field of flat panel displays (FPD), and commercial products are becoming increasingly available.
Depending on the organic material used, organic EL elements can be broadly classified into two types: low-molecular weight type organic EL elements that use a low-molecular weight compound, and polymer type organic EL elements that use a polymer compound. Further, the production methods for organic EL elements are broadly classified into dry processes in which film formation is mainly performed in a vacuum system, and coating processes in which film formation is performed by plate-based printing such as relief printing or intaglio printing, or by plateless printing such as inkjet printing. Because coating processes enable simple film formation, they are expected to be an indispensable method in the production of future large-screen organic EL displays.
Examples of materials that have been disclosed for use in coating processes include organic electronic materials disclosed in WO 2010/140553 containing a polymer or oligomer having a structure branched in three or more directions.

CITATION LIST

PATENT DOCUMENT

Patent Document 1: WO 2010/140553

SUMMARY OF THE INVENTION

TECHNICAL PROBLEM

In order to improve the efficiency and lengthen the lifespan of organic EL elements, techniques that employ multiple layers of organic layers to separate the functions of the individual layers are being investigated. However, in coating processes, if multilayering is performed using ink compositions, then a problem can sometimes arise in that when an upper layer is applied, the solvent contained in the upper layer may dissolve the lower layer.
Embodiments of the present invention have been designed in light of these circumstances, and have objects of providing an organic electronic material and an ink composition that are suited to coating processes and enable the formation of organic layers having excellent solvent resistance. Another embodiment of the present invention has an object of providing an organic layer that is suitable for improving the characteristics of organic electronic elements. Other embodiments of the present invention have objects of providing an organic electronic element, an organic EL element, a display element, an illumination device and a display device having excellent characteristics.

SOLUTION TO PROBLEM

One embodiment of the present invention relates to an organic electronic material containing a polymer or oligomer having a structural unit that has hole transport properties, and also having an alkyl chain of 6 to 20 carbon atoms.
Another embodiment of the present invention relates to an ink composition containing the organic electronic material described above and a solvent.
Another embodiment of the present invention relates to an organic layer formed using the organic electronic material described above or the ink composition described above.
Another embodiment of the present invention relates to an organic electronic element including at least one of the organic layer described above.
Another embodiment of the present invention relates to an organic electroluminescent element including at least one of the organic layer described above.
Another embodiment of the present invention relates to a display element including the organic electroluminescent element described above.

Another embodiment of the present invention relates to an illumination device including the organic electroluminescent element described above.

Another embodiment of the present invention relates to a display device including the illumination device described above, and a liquid crystal element as a display unit.

ADVANTAGEOUS EFFECTS OF THE INVENTION

According to embodiments of the present invention, it is possible to provide an organic electronic material and an ink composition that are suited to coating processes and enable the formation of organic layers having excellent solvent resistance. According to another embodiment of the present invention, it is possible to provide an organic layer that is suitable for improving the characteristics of organic electronic elements. According to other embodiments of the present invention, it is possible to provide an organic electronic element, an organic EL element, a display element, an illumination device and a display device that have excellent characteristics.

BRIEF DESCRIPTION OF THE DRAWINGS

FIG. 1 is a cross-sectional schematic view illustrating one example of an organic EL element according to an embodiment of the present invention.

DESCRIPTION OF EMBODIMENTS

Embodiments of the present invention are described below, but the present invention is not limited to these embodiments.

[Organic Electronic Material]

The organic electronic material of an embodiment of the present invention contains a polymer or oligomer (hereafter sometimes referred to as "the polymer (A)") having a structural unit that has hole transport properties, and also having an alkyl chain of 6 to 20 carbon atoms.

The organic electronic material may also contain one or more other components such as an initiator or a solvent as required. The organic electronic material may contain only one type of the polymer (A), or may contain two or more types thereof. Other components such as the initiator or solvent that may be optionally included may also each be composed of only one type of material or a plurality of materials.

Generally, it is thought that the solvent resistance can be improved by using a polymer or oligomer having a polymerizable functional group that initiates a crosslinking reaction. Further, the solvent resistance tends to improve as the amount of the polymerizable functional group in the polymer or oligomer is increased.

However, in those cases where a polymer or oligomer having a polymerizable functional group is used, when the organic EL element is driven, uncrosslinked polymerizable functional groups, or structures that have bonded by crosslinking may sometimes cause a deterioration in the organic EL element characteristics.

It has been discovered that, according to the present embodiment, surprisingly, when the polymer (A) having an alkyl chain of 6 to 20 carbon atoms is used in the formation of an organic layer, an improvement in the solvent resistance is obtained. By including the alkyl chain of 6 to 20 carbon atoms in the polymer (A), it is possible to improve the curability even if the amount of polymerizable functional groups in the polymer is small, and it is also possible to form an organic layer with superior solvent resistance. Accordingly, the organic electronic material of the present embodiment is suitable for application to ink compositions for use in coating processes.

Although only a hypothesis, it is thought that when the organic electronic material is applied as a thin film, and heating is then conducted at high temperature to volatilize the solvent, the long alkyl chains of adjacently located molecules of the polymer (A) become intertwined, whereby the solvent resistance following curing can be enhanced.

Further, it has been discovered that by enabling a reduction in the amount of polymerizable functional groups, which is one cause of degradation in organic EL elements, in an organic EL element that uses this type of organic layer, effects such as an improvement in the light emission characteristics, an improvement in emission efficiency, and an improvement in emission lifespan can be achieved.

Furthermore, using the polymer (A) having an alkyl chain of 6 to 20 carbon atoms also enables improvements in the emission efficiency and the emission lifespan.

[Polymer (A)]

The polymer (A) has a structural unit having hole transport properties, and has an alkyl chain of 6 to 20 carbon atoms.

The polymer (A) may be a linear polymer, or a polymer having a branched structure in the molecule and having three or more terminals. A branched structure describes a structure in which the polymer chain has a branched portion, with structural units in three or more directions from the branched portion. A polymer (A) having a branched structure and having three or more terminals includes a main chain and one or more side chains.

In the following description of structural units, an aryl group is an atom grouping in which one hydrogen atom has been removed from an aromatic hydrocarbon. A heteroaryl group is an atom grouping in which one hydrogen atom has been removed from an aromatic heterocycle. An arylene group is an atom grouping in which two hydrogen atoms have been removed from an aromatic hydrocarbon. A heteroarylene group is an atom grouping in which two hydrogen atoms have been removed from an aromatic heterocycle. An arenetriyl group is an atom grouping in which three hydrogen atoms have been removed from an aromatic hydrocarbon. A heteroarenetriyl group is an atom grouping in which three hydrogen atoms have been removed from an aromatic heterocycle. Examples of the aromatic hydrocarbon include monocyclic rings, condensed rings, and polycyclic rings in which two or more rings selected from among monocyclic rings and condensed rings are bonded together via a single bond (single bonds). Examples of the aromatic heterocycles include monocyclic rings, condensed rings, and polycyclic rings in which two or more rings selected from among monocyclic rings and condensed rings are bonded together via a single (single bonds).

Examples of the aromatic hydrocarbon include benzene, biphenyl, terphenyl, triphenylbenzene, naphthalene, anthracene, tetracene, fluorene and phenanthrene.

Examples of the aromatic heterocycles include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole and benzothiophene.

The structural unit having hole transport properties may be any structural unit that has the ability to transport a positive hole, and examples include structural units containing an aromatic amine structure, structural units containing a carbazole structure, structural units containing a thiophene structure, structural units containing a fluorene structure, and structural units containing a furan structure and the like. Preferable examples include structural units containing an aromatic amine structure and structural units containing a carbazole structure. For the aromatic amine structure, a tertiary aromatic amine structure is preferred, and a triarylamine structure (tertiary aromatic hydrocarbon structure) is more preferred. The number of carbon atoms in the aryl group is preferably from 6 to 14, more preferably from 6 to 10, and is even more preferably 6. From the viewpoint of obtaining superior charge transport properties, a triphenylamine structure is particularly preferred as the aromatic amine structure. The aromatic amine structure, carbazole structure, thiophene structure, fluorene structure or furan structure may be unsubstituted, or may have a substituent. Examples of the substituent include the same groups as the group E in formulas (1a) to (84a) described below. Specific examples of the substituent include alkyl chains of 6 to 20 carbon atoms.

The polymer (A) may have two or more types of these structural units having hole transport properties.

In the polymer (A), it is preferable that at least one structure having hole transport properties has an alkyl chain of 6 to 20 carbon atoms.

The polymer (A) may be a polymer of a monomer containing a structural unit having hole transport properties, or may be a copolymer containing a plurality of types of structural units having hole transport properties and/or containing one or more other structural units.

The copolymer may be an alternating, random, block or graft copolymer, or may be a copolymer having an intermediate type structure, such as a random copolymer having block-like properties.

Examples of structural units having hole transport properties include formulas (1a) to (93a) shown below. The structural units represented by formula (85a) to (93a) have branched portions.

<Formulas (1a) to (84a)>

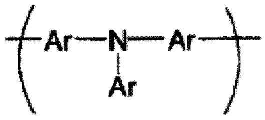

(1a)

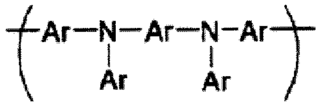

(2a)

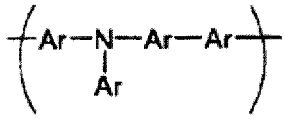

(3a)

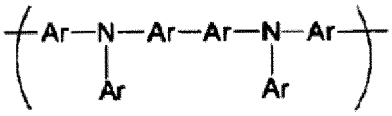

(4a)

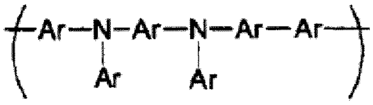

(5a)

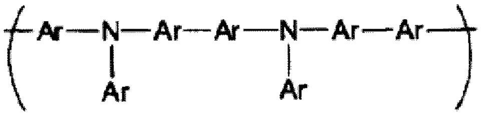

(6a)

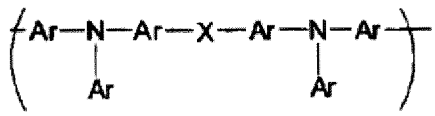

(7a)

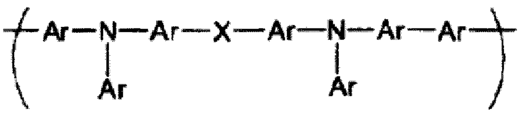

(8a)

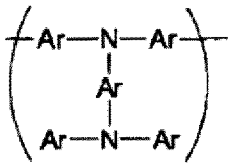

(9a)

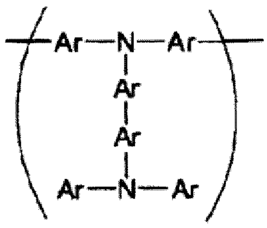

(10a)

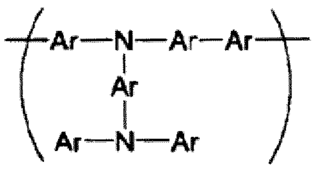

(11a)

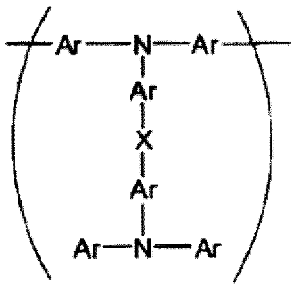

(12a)

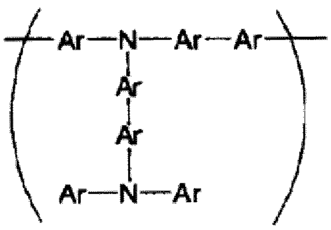

(13a)

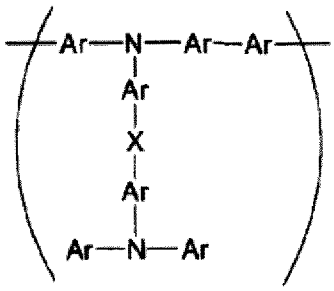

(14a)

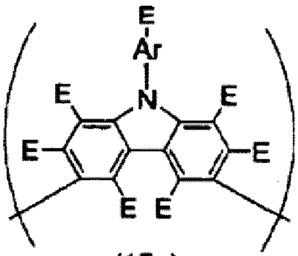
(15a)

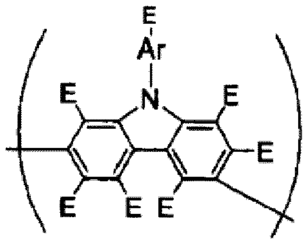
(16a)

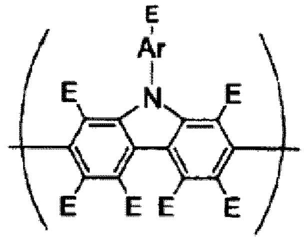
(17a)

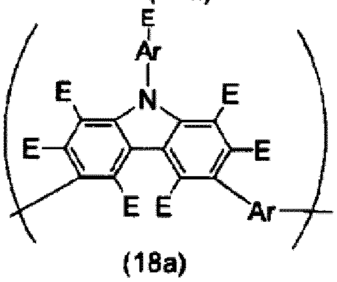
(18a)

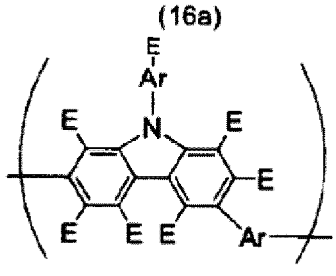
(19a)

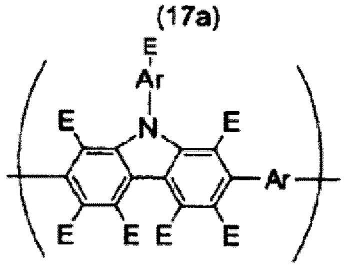
(20a)

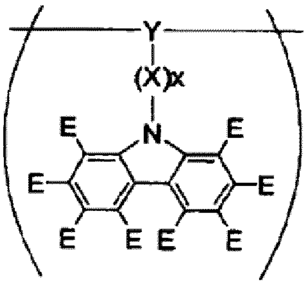
(21a)

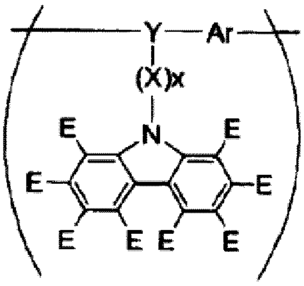
(22a)

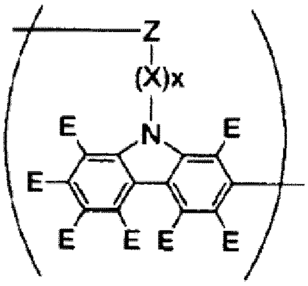
(23a)

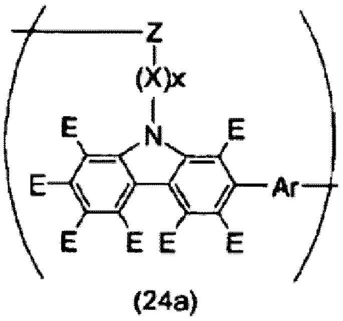
(24a)

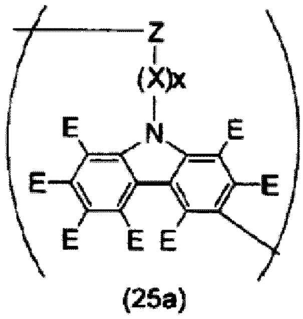
(25a)

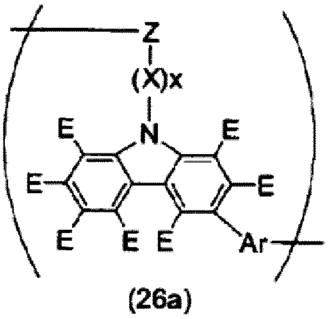
(26a)

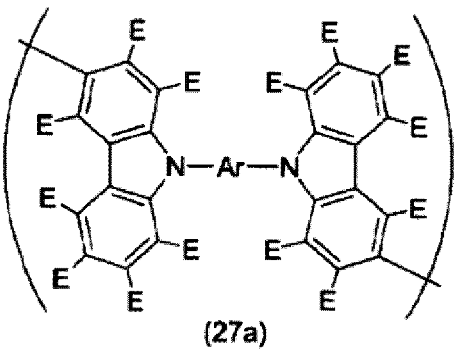
(27a)

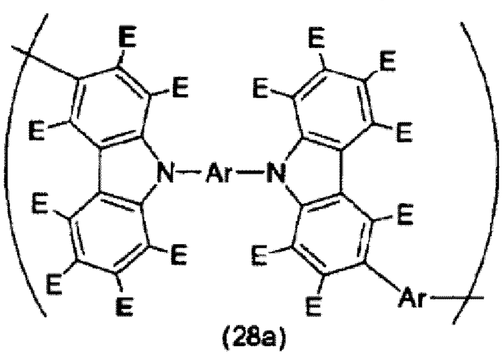
(28a)

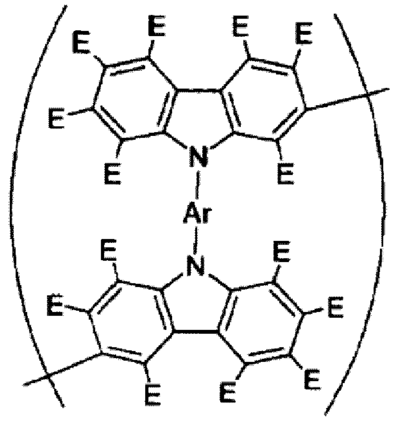

(29a)

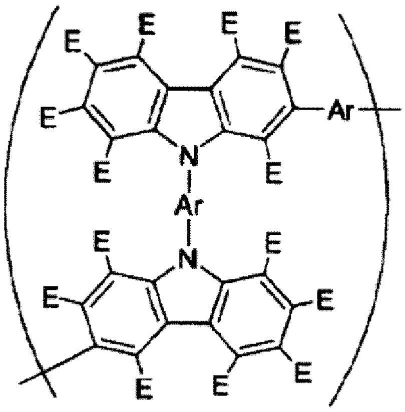

(30a)

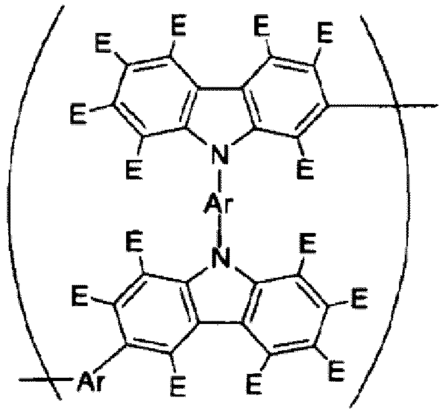

(31a)

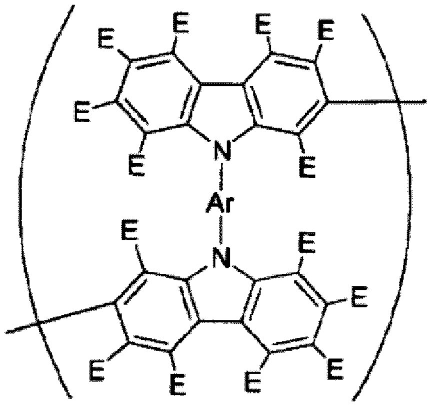

(32a)

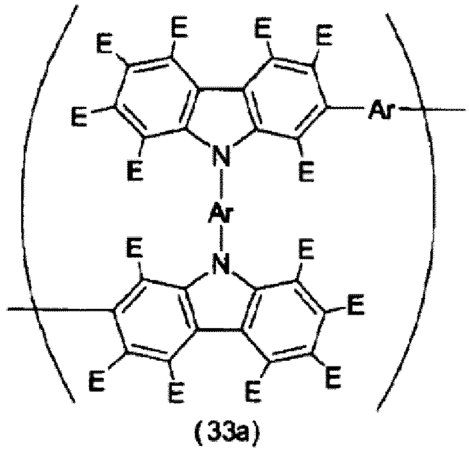

(33a)

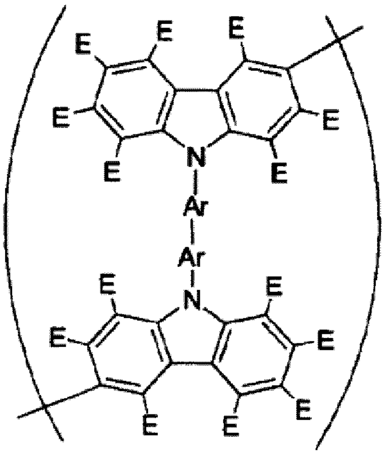

(34a)

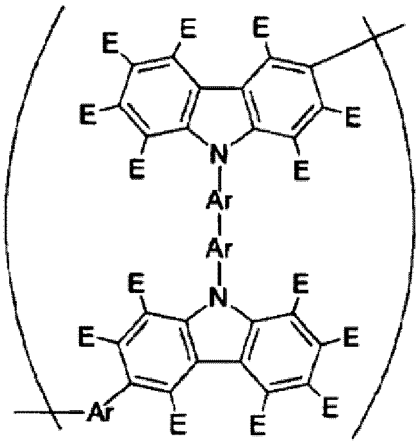

(35a)

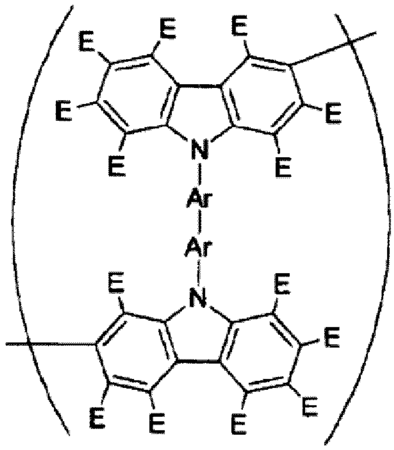

(36a)

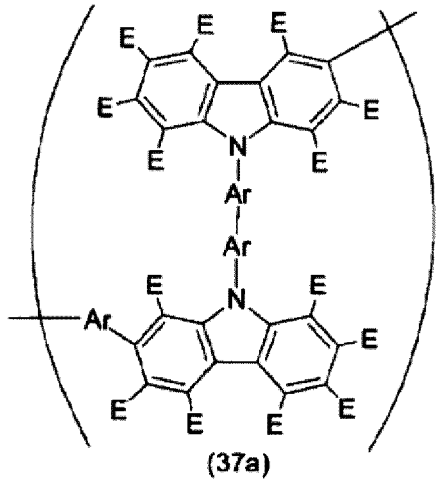

(37a)

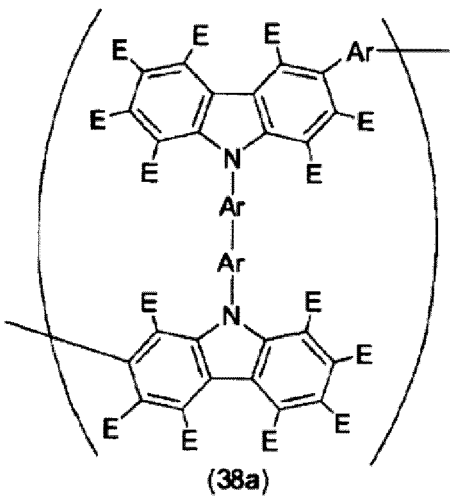

(38a)

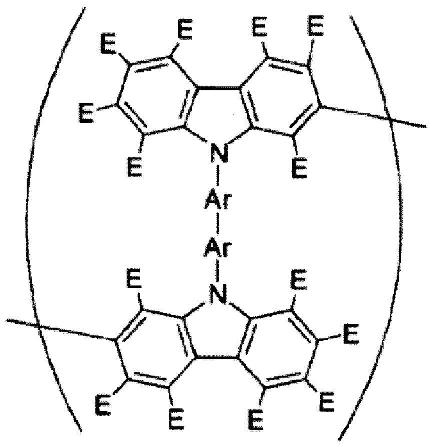

(39a)

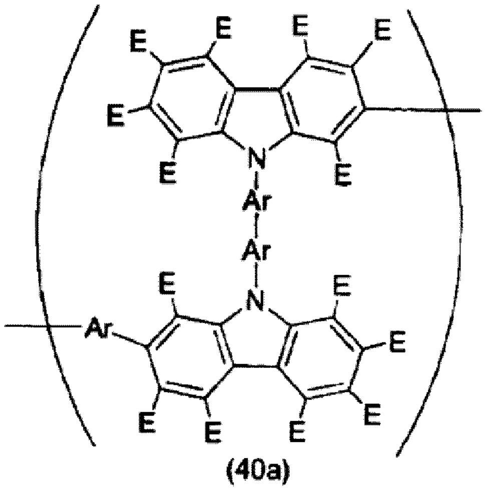

(40a)

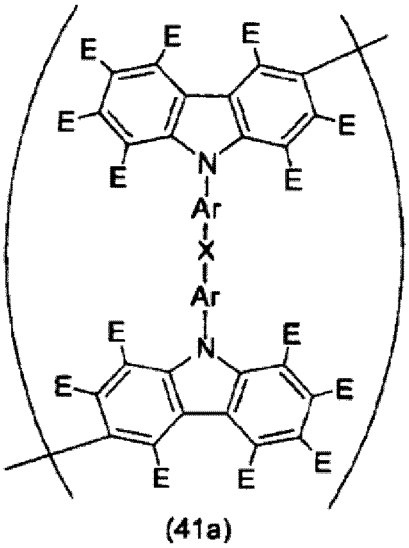

(41a)

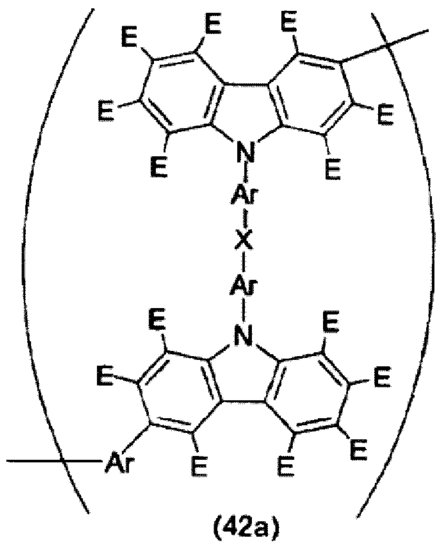

(42a)

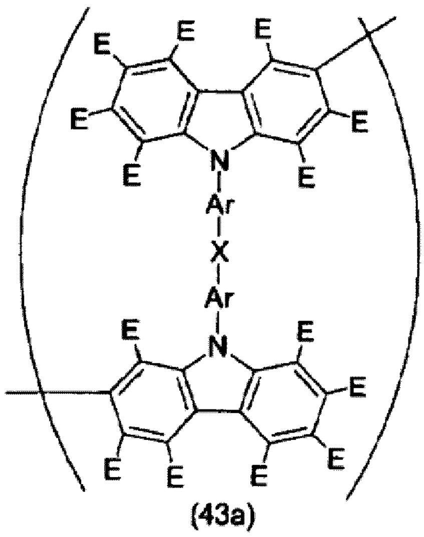

(43a)

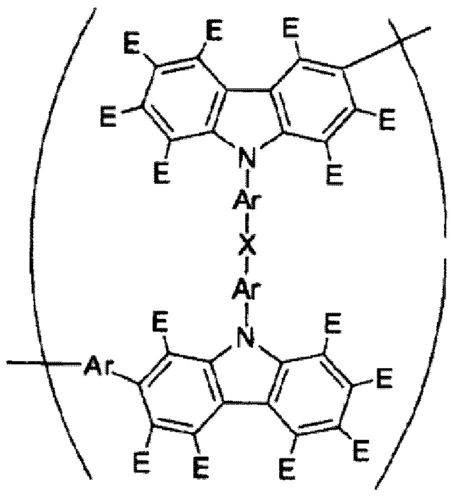

(44a)

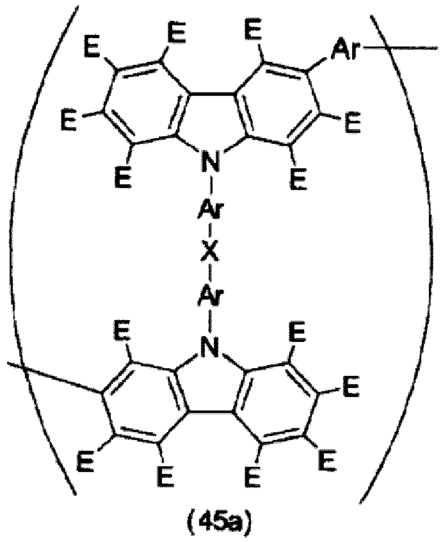

(45a)

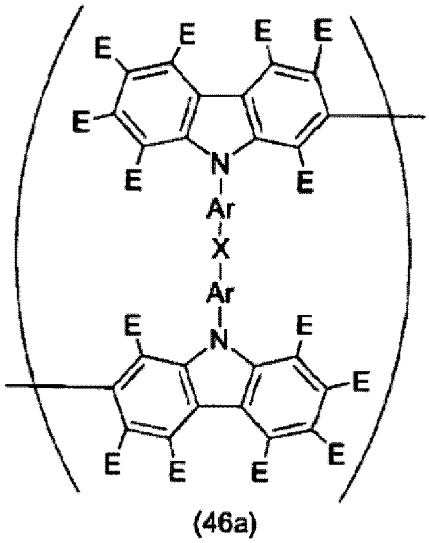

(46a)

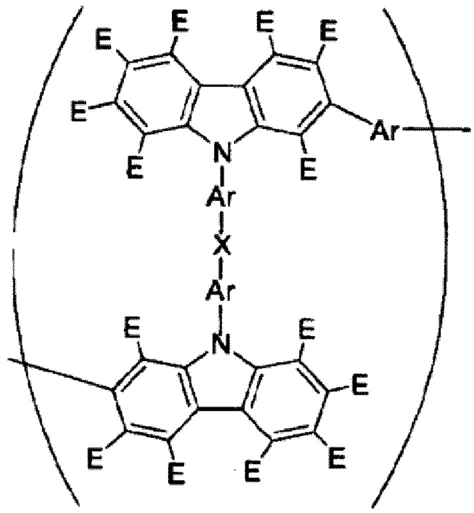

(47a)

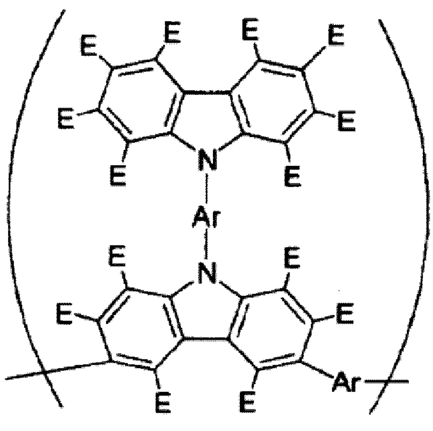

(48a)

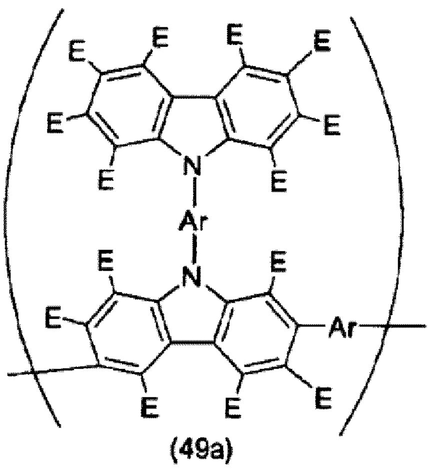

(49a)

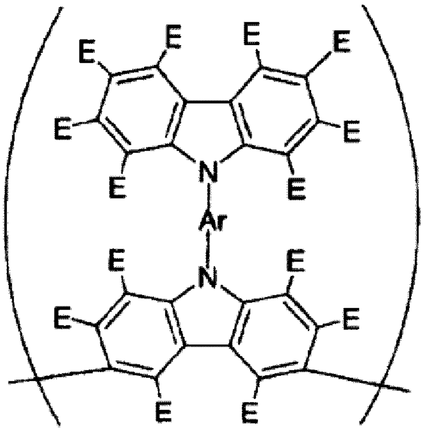

(50a)

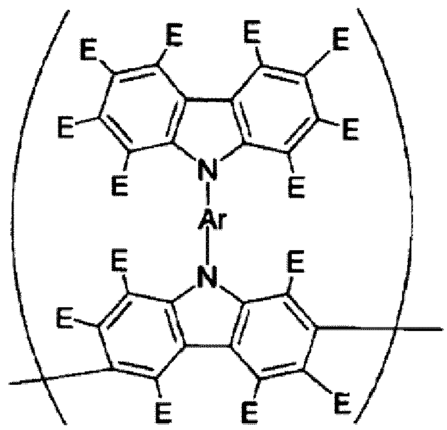

(51a)

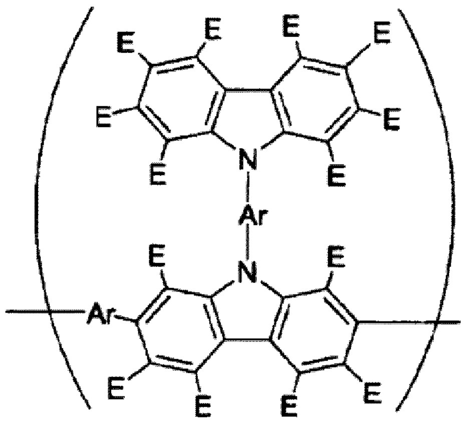

(52a)

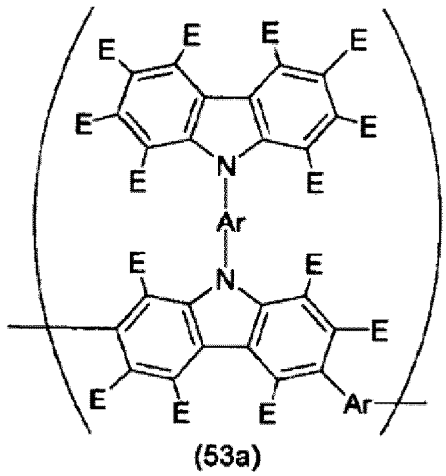

(53a)

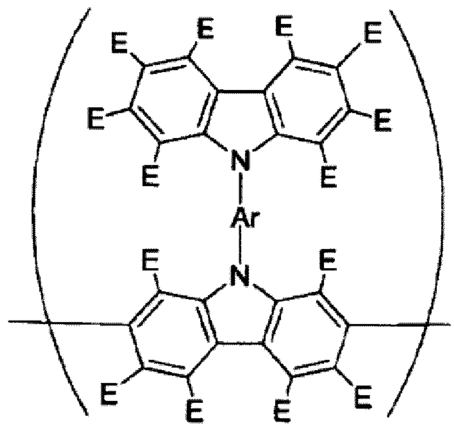

(54a)

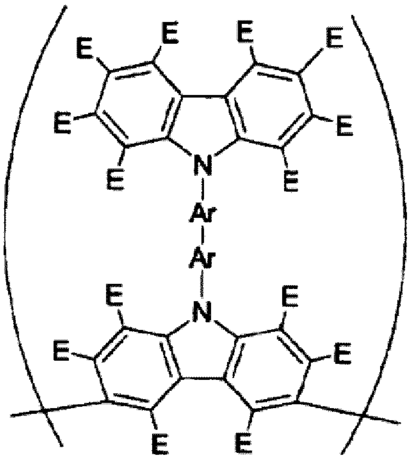

(55a)

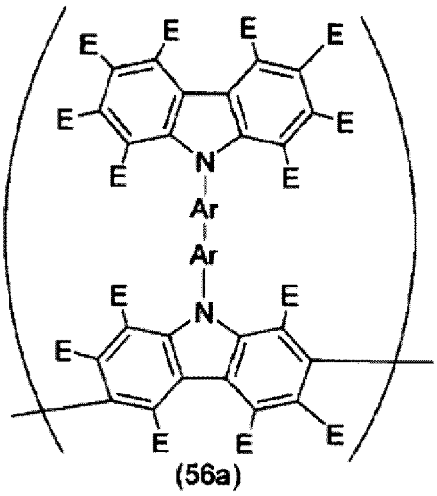

(56a)

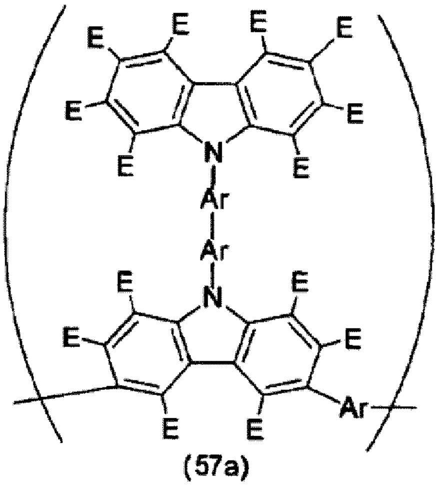

(57a)

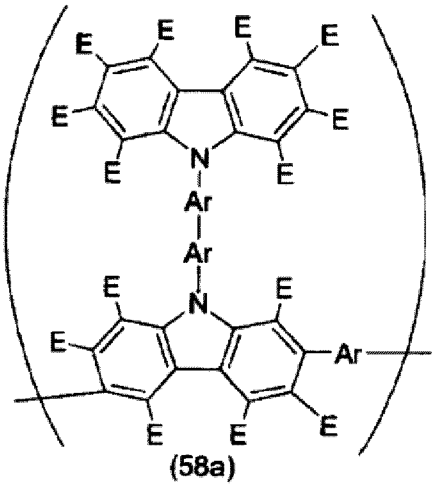

(58a)

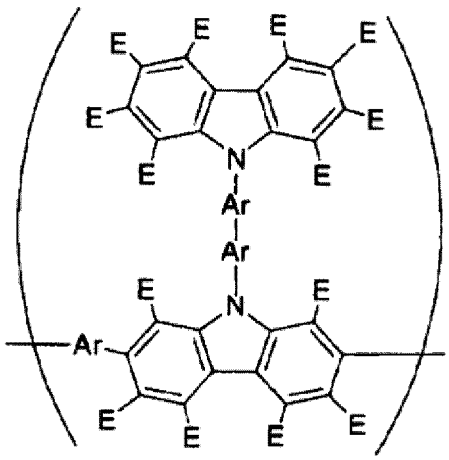

(59a)

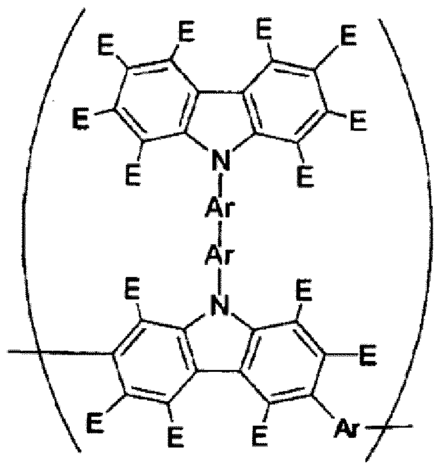

(60a)

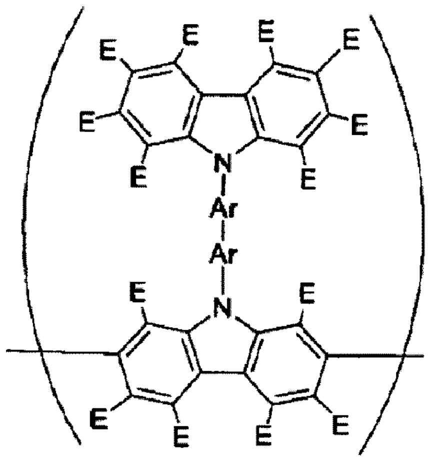

(61a)

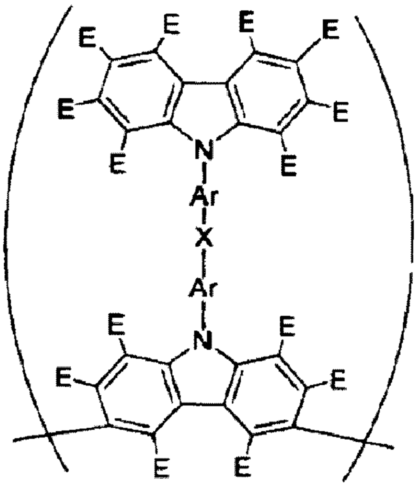

(62a)

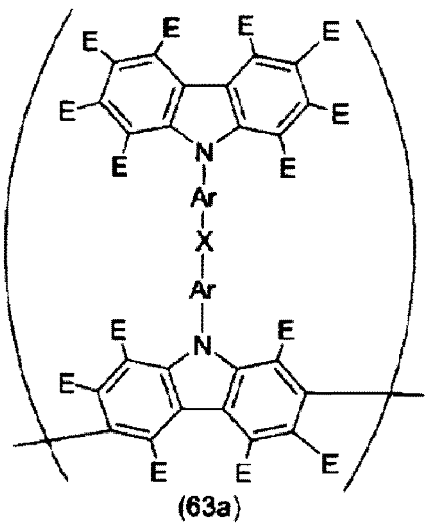

(63a)

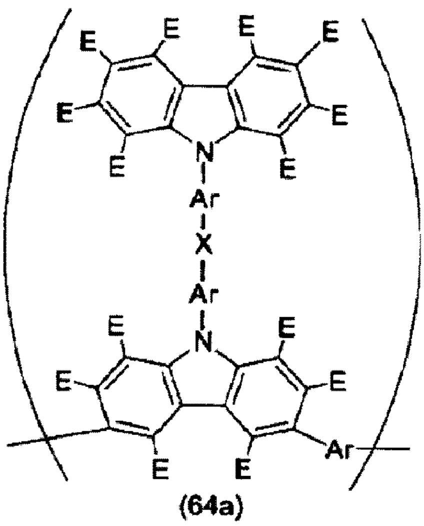

(64a)

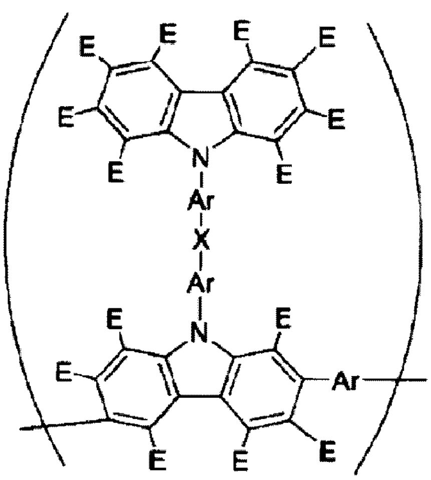

(65a)

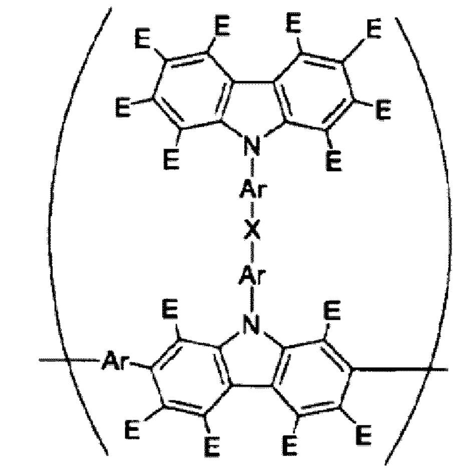

(66a)

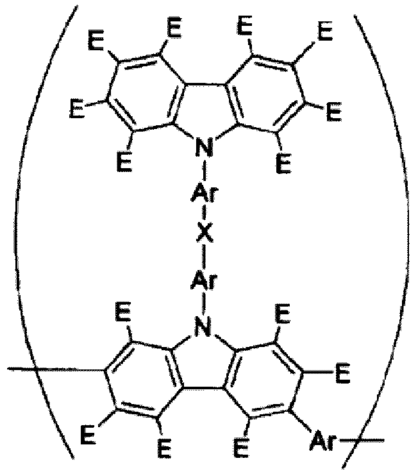

(67a)

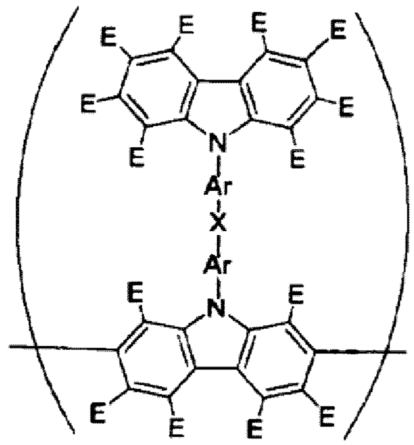

(68a)

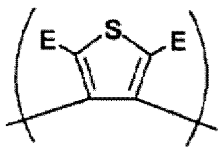

(69a)

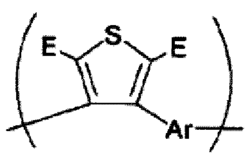

(70a)

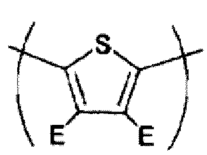

(71a)

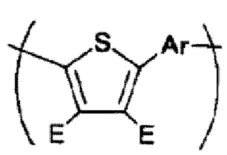

(72a)

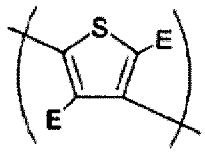

(73a)

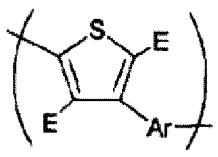

(74a)

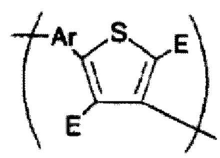

(75a)

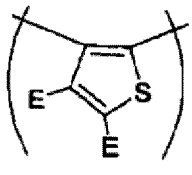
(76a)

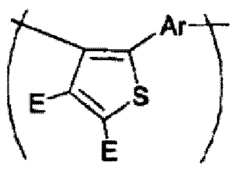
(77a)

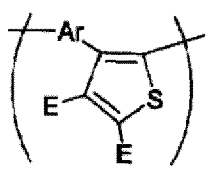
(78a)

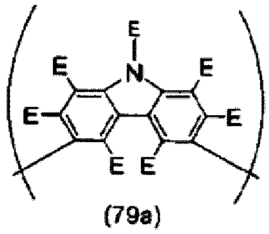
(79a)

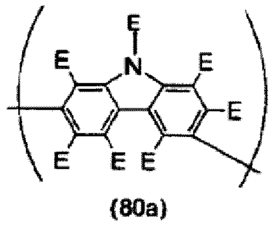
(80a)

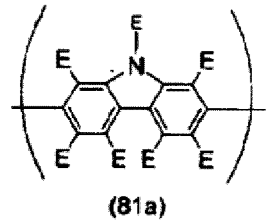
(81a)

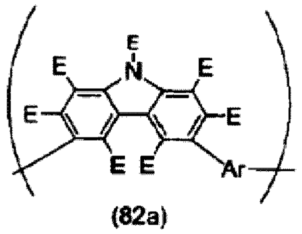
(82a)

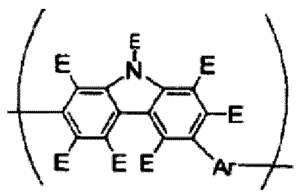
(83a)

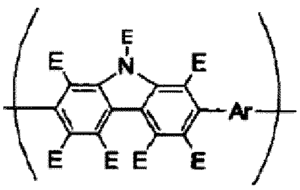
(84a)

In formulas (1a) to (84a), each E independently represents $-R^1$, $-OR^2$, $-SR^3$, $-OCOR^4$,$-COOR^5$, $-SiR^6R^7R^8$, or any of formulas (a) to (c) shown below.

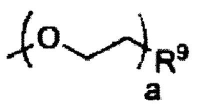
( a )

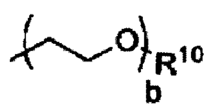
( b )

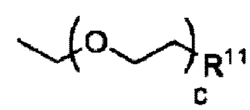
( c )

Each of $R^1$ to $R^{11}$ represents a hydrogen atom, a linear, cyclic or branched alkyl group of 1 to 22 carbon atoms, or an aryl group or heteroaryl group of 2 to 30 carbon atoms, and each of a, b and c represents an integer of 1 or greater. The aryl group may have a substituent, and the heteroaryl group may have a substituent. Examples of the these substituents include an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a hydroxyl group, a hydroxyalkyl group, an amino group, a substituted amino group, a silyl group, a substituted silyl group, a silyloxy group, a substituted silyloxy group, a halogen atom, an acyl group, an acyloxy group, an imino group, an amide group (-(NH)-COR), an imide group ($-N(COR)_2$), a carboxyl group, a substituted carboxyl group, a cyano group, or a monovalent heterocyclic group. Each of a, b and c preferably represents an integer of 1 to 4.

In the above description, examples of the alkyl group include a methyl group, an ethyl group, an n-propyl group, an n-butyl group, an n-pentyl group, an n-hexyl group, an n-heptyl group, an n-octyl group, an n-nonyl group, an n-decyl group, an n-undecyl group, an n-dodecyl group, an isopropyl group, an isobutyl group, a sec-butyl group, a tert-butyl group, a 2-ethylhexyl group, a 3,7-dimethyloctyl group, a cyclohexyl group, a cycloheptyl group and a cyclooctyl group.

Examples of the aryl group include a phenyl group, a biphenylyl group, a terphenylyl group, a naphthalenyl group, an anthracenyl group, a tetracenyl group, a fluorenyl group and a phenanthrenyl group.

Examples of the heteroaryl group include a pyridinyl group, a pyrazinyl group, a quinolinyl group, an isoquinolinyl group, an acridinyl group, a phenanthrolinyl group, a furanyl group, a pyrrolyl group, a thiophenyl group, a carbazolyl group, an oxazolyl group, an oxadiazolyl group, a thiadiazolyl group, a triazolyl group, a benzoxazolyl group, a benzoxadiazolyl group, a benzothiadiazolyl group, a benzotriazolyl group and a benzothiophenyl group. Examples of alkyl groups, aryl groups and heteroaryl groups mentioned in the following description include these same groups.

Each Ar independently either represents an arylene group or heteroarylene group of 2 to 30 carbon atoms, or represents an aryl group or heteroaryl group of 2 to 30 carbon atoms. The arylene group, heteroarylene group, aryl

group and heteroaryl group may each have a substituent. Examples of the substituent include the same groups as those mentioned above for E.

Examples of the arylene group include a phenylene group, a biphenyldiyl group, a terphenyldiyl group, a napthalenediyl group, an anthracenediyl group, a tetracenediyl group, a fluorenediyl group, and a phenanthrenediyl group. Examples of the heteroarylene group include a pyridinediyl group, a pyrazinediyl group, a quinolinediyl group, an isoquinolinediyl group, an acridinediyl group, a phenanthrolinediyl group, a furandiyl group, a pyrrolyediyl group, a thiophenediyl group, a carbazolediyl group, an oxazolediyl group, an oxadiazolediyl group, a thiadiazolediyl group, a triazolediyl group, a benzoxazolediyl group, a benzoxadiazolediyl group, a benzothiadiazolediyl group, a benzotriazolediyl group and a benzothiophenediyl group. Examples of arylene groups (arenediyl groups) and heteroarylene groups (heteroarenediyl groups) mentioned in the following description include these same groups.

Each of X and Z independently represents a divalent linking group, and although there are no particular limitations, each of X and Z independently preferably a group in which an additional one hydrogen atom has been removed from any of the aforementioned E groups having at least one hydrogen atom, or a group included in the linking group series (A) shown below. Further, x represents an integer of 0 to 2. Y represents a trivalent linking group, and although there are no particular limitations, a group in which an additional two hydrogen atoms have been removed from any of the aforementioned E groups having at least two hydrogen atoms is preferred.

<Linking Group Series (A)>

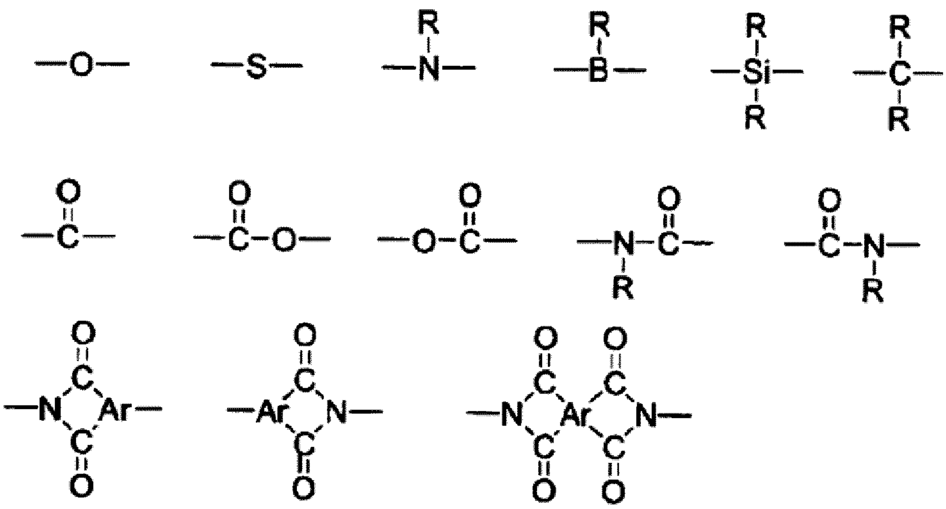

In the formulas, each R independently represents a hydrogen atom, a linear, cyclic or branched alkyl group of 1 to 22 carbon atoms which may have a substituent, or an aryl group or heteroaryl group of 2 to 30 carbon atoms which may have a substituent. Ar represents a trivalent or tetravalent linking group, and is preferably a group in which an additional one or two hydrogen atoms have been removed from an arylene group or heteroarylene group of 2 to 30 carbon atoms.

<Formulas (85a) to (93a)>

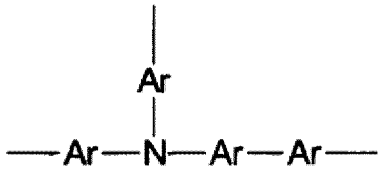

(85a)

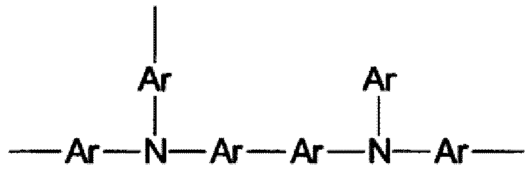

(86a)

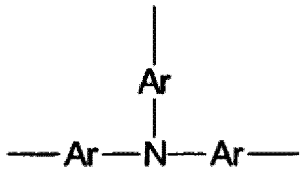

(87a)

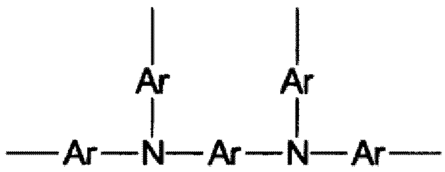

(88a)

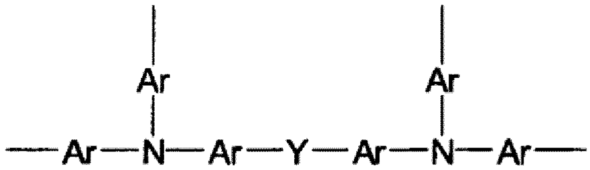

(89a)

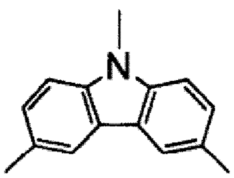

(90a)

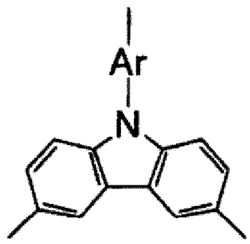

(91a)

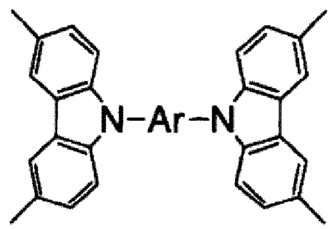

(92a)

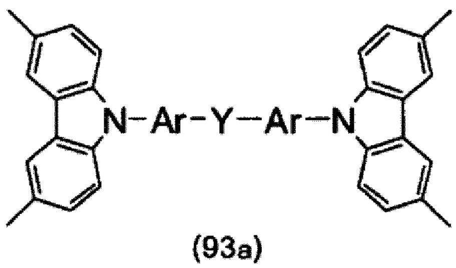

(93a)

In formulas (85a) to (93a), each Ar independently represents an arylene group or heteroarylene group of 2 to 30 carbon atoms, or represents an aryl group or heteroaryl group of 2 to 30 carbon atoms, and Y represents a divalent linking group. The units represented by formulas (85a) to (93a) may each have a substituent, and examples of the substituent include the same groups as those mentioned above for E in formulas (1a) to (84a).

In formulas (89a) and (93a), Y is preferably a divalent linking group represented by one of the formulas shown below.

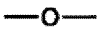 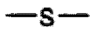 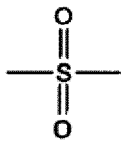 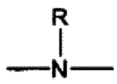 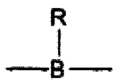 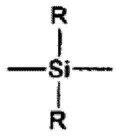 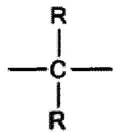

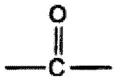 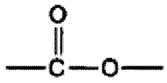 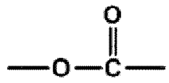 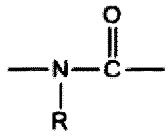 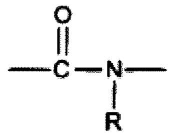

In these formulas, each R independently represents a hydrogen atom, a linear, cyclic or branched alkyl group of 1 to 22 carbon atoms which may have a substituent, or an aryl group or heteroaryl group of 2 to 30 carbon atoms which may have a substituent.

Examples of the formulas (85a) and (86a) include formulas (85a-1) and (86a-1) shown below. In the following description, only examples for formulas (85a) and (86a) are shown, but examples for formulas (87a) to (89a) and (91a) to (93a) similarly include units in which Ar is a benzene ring which may have a substituent.

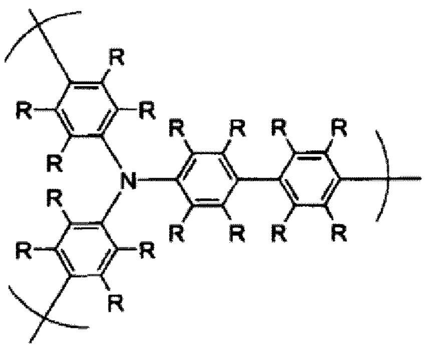

(85a-1)

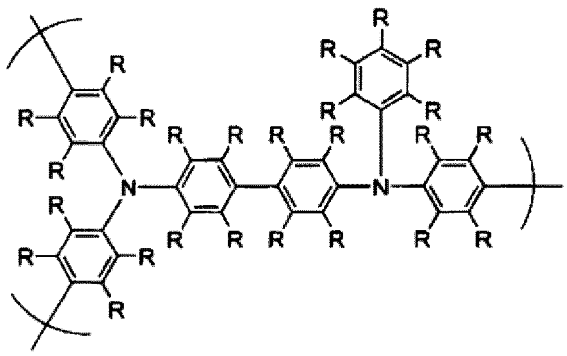

(86a-1)

In formulas (85a-1) and (86a-1), each R independently represents a hydrogen atom, a halogen atom, or a monovalent organic group. Examples of the monovalent organic group for R include a linear, cyclic or branched alkyl group of 1 to 22 carbon atoms, or an aryl group or heteroaryl group of 2 to 30 carbon atoms, and a group in which any these groups are bonded together via an ether linkage may be included.

In order to enable adjustment of the degree of solubility, the heat resistance or the electrical characteristics, the polymer (A) may be a copolymer which, besides the structural unit described above, has an arylene group or heteroarylene group described above, or a structure represented by one of formulas (1) to (32) shown below, as a copolymerization structural unit. Structural units represented by formulas (30) to (32) have a branched portion.

<Formulas (1) to (28)>

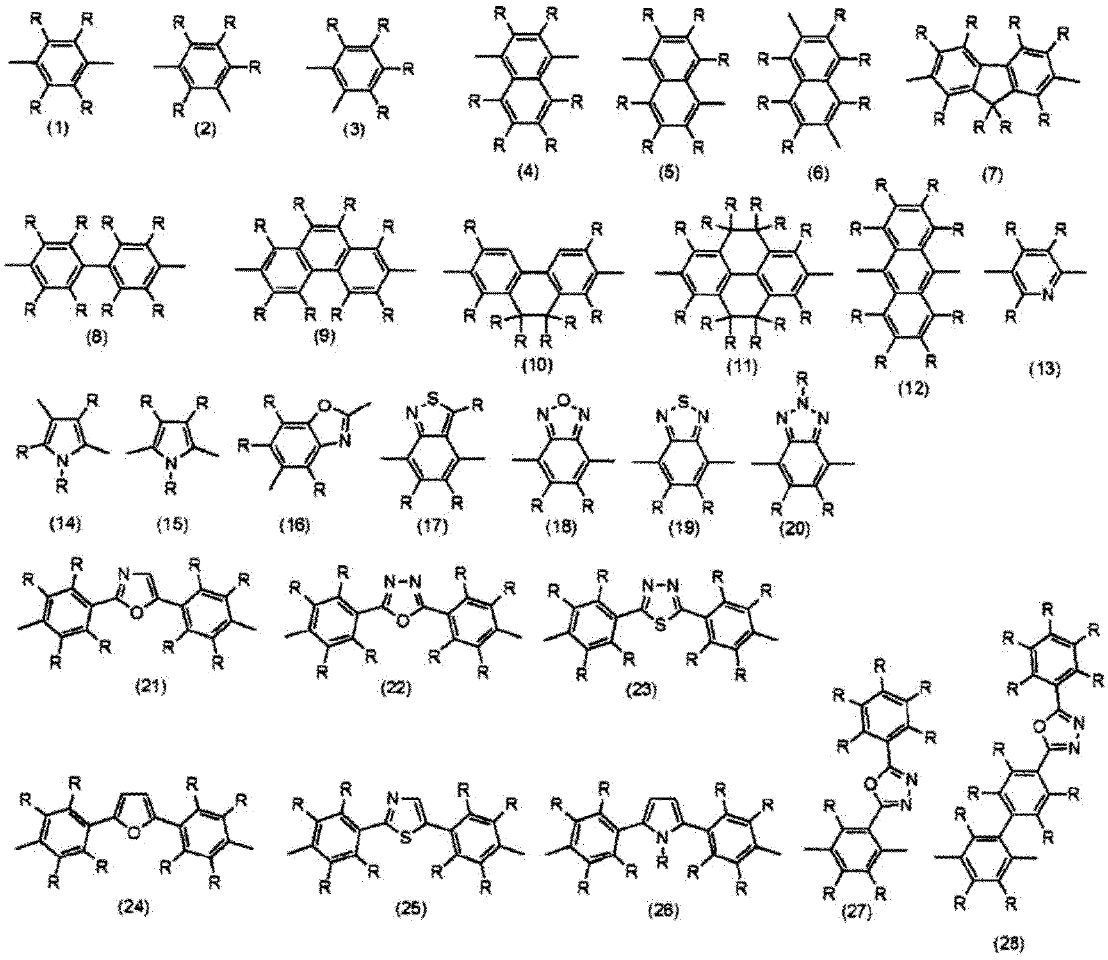

(1) (2) (3) (4) (5) (6) (7) (8) (9) (10) (11) (12) (13) (14) (15) (16) (17) (18) (19) (20) (21) (22) (23) (24) (25) (26) (27) (28)

In formulas (1) to (28), examples of R include the same groups as those mentioned above for E in formulas (1a) to (84a).

<Formula (29)>

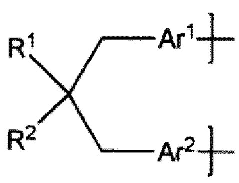

( 2 9 )

In formula (29), each of $R^1$ and $R^2$ is independently selected from the group consisting of a hydrogen atom, and substituents composed of C, H and/or X (wherein X represents a hetero atom), and each of $Ar^1$ and $Ar^2$ independently represents a group selected from the group consisting of divalent aromatic rings composed of C and H, and divalent aromatic rings composed of C, H and X (wherein X represents a hetero atom). Cases in which $R^1$ and $R^2$ are both hydrogen atoms are excluded. Further, C represents a carbon atom and H represents a hydrogen atom. Examples of X include O (an oxygen atom), N (a nitrogen atom), S (a sulfur atom), Si (a silicon atom), and halogen atoms.

Examples of the substituent composed of C, H and/or X for $R^1$ and $R^2$ include aliphatic substituents composed of C and H, aromatic substituents composed of C and H, aromatic substituents composed of C, H and X, and other

substituents composed of C, H and/or X (including aliphatic substituents). Examples of the divalent aromatic rings composed of C and H for $Ar^1$ and $Ar^2$ include divalent aromatic hydrocarbon rings including single rings and condensed ring structures composed of two or more, and preferably 2 to 5, condensed rings. Examples of the divalent aromatic rings composed of C, H and X (wherein X represents a hetero atom) include divalent heterocyclic aromatic rings including heterocyclic single rings and condensed ring structures composed of two or more, and preferably 2 to 5, condensed rings. Each of the $Ar^1$ and $Ar^2$ groups may also have a substituent.

Specific examples of $R^1$ and $R^2$ include the same groups as those mentioned above for E in formulas (1a) to (84a). Specific examples of $Ar^1$ and $Ar^2$ include the same groups as those mentioned above for Ar in formulas (1a) to (84a).

<Formulas (30) to (32)>

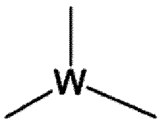
(30)

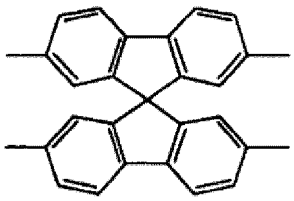
(31)

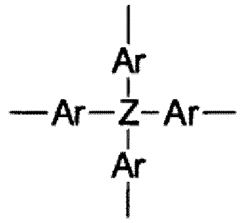
(32)

In formulas (30) to (32), W represents a trivalent linking group, and is preferably an atom grouping in which an additional one hydrogen atom has been removed from an arylene group or heteroarylene group of 2 to 30 carbon atoms. Each Ar independently represents an arylene group or heteroarylene group of 2 to 30 carbon atoms, and Z represents a carbon atom, a silicon atom or a phosphorus atom. The units represented by formulas (30) to (32) may each have a substituent, and examples of the substituent include the same groups as those mentioned above for E in formulas (1a) to (84a).

The polymer (A) preferably has an alkyl chain of 6 to 20 carbon atoms. The polymer (A) may have the alkyl chain of 6 to 20 carbon atoms as a substituent of a structural unit that is included in either the main chain or a side chain. The structural unit that is included in the main chain or a side chain may be a structural unit represented by one of the above formulas (1a) to (93a) and formulas (1) to (32).

The alkyl chain of 6 to 20 carbon atoms is a linear alkyl group of 6 to 20 carbon atoms. The number of carbon atoms in the alkyl chain of 6 to 20 carbon atoms is more preferably from 7 to 18, even more preferably from 7 to 16, and still more preferably from 8 to 12.

Examples of the alkyl chain of 6 to 20 carbon atoms include an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, an n-nonadecyl group and an n-eicosyl group.

Examples of the polymer (A) include polymers having at least one group selected from the group consisting of aryl groups, heteroaryl groups, arylene groups, heteroarylene groups, arenetriyl groups and heteroarenetriyl groups that have an alkyl chain of 6 to 20 carbon atoms as a substituent. The aryl group, heteroaryl group, arylene group, heteroarylene group, arenetriyl group or heteroarenetriyl group having the alkyl chain of 6 to 20 carbon atoms as a substituent may also have another substituent besides the alkyl chain of 6 to 20 carbon atoms.

Examples of the arenetriyl group include a benzenetriyl group, a biphenyltriyl group, a terphenyltriyl group, a naphthalenetriyl group, an antracenetriyl group, a tetracenetriyl group, a fluorenetriyl group and a phenanthrenetriyl group. Examples of the heteroarenetriyl group include a pyridinetriyl group, a pyrazinetriyl group, a quinolinetriyl group, an isoquinolinetriyl group, an acridinetriyl group, a phenanthrolinetriyl group, a furantriyl group, a pyrrolyetriyl group, a thiophenetriyl group, a carbazoletriyl group, an oxazoletriyl group, an oxadiazoletriyl group, a thiadiazoletriyl group, a triazoletriyl group, a benzoxazoletriyl group, a benzoxadiazoletriyl group, a benzothiadiazoletriyl group, a benzotriazoletriyl group and a benzothiophenetriyl group. Examples of arenetriyl groups and heteroarenetriyl groups mentioned in the following description include these same groups.

Examples of the polymer (A) include polymers having a structure represented by formula (Ia) shown below.

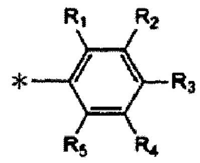

Formula (Ia)

Each of $R^1$ to $R^5$ in formula (Ia) independently represents a hydrogen atom or an alkyl group. The alkyl group for $R^1$ to $R^5$ is preferably a linear alkyl group of 6 to 20 carbon atoms (more preferably 7 to 18 carbon atoms, even more preferably 7 to 16 carbon atoms, and still more preferably 8 to 12 carbon atoms). At least one of $R^1$ to $R^5$ is a linear alkyl group of 6 to 20 carbon atoms (preferably 7 to 18 carbon atoms, more preferably 7 to 16 carbon atoms, and even more preferably 8 to 12 carbon atoms). The symbol "*" indicates a bonding site with another structure.

Formula (Ia) may be bonded to, for example, an arylene group, a heteroarylene group, an arenetriyl group, a heteroarenetriyl group, a nitrogen atom or the like, at the bonding site with other structures indicated by *. For example, the structure of formula (Ia) may be bonded to a nitrogen atom at the bonding site *, and may form an aromatic amine structure such as a triarylamine structure in combination with the other structures bonded to the nitrogen atom.

Examples of the polymer (A) include polymers having structures represented by formula (IIa) or (IIIa) shown below.

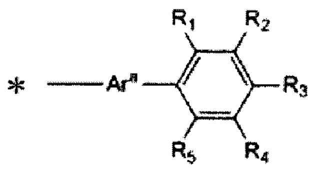

Formula (IIa)

Each of $R^1$ to $R^5$ in formula (IIa) independently represents a hydrogen atom or an alkyl group. The alkyl group for $R^1$ to $R^5$ is preferably a linear alkyl group of 6 to 20 carbon atoms (more preferably 7 to 18 carbon atoms, even more preferably 7 to 16 carbon atoms, and still more preferably 8 to 12 carbon atoms). At least one of $R^1$ to $R^5$ is a linear alkyl group of 6 to 20 carbon atoms (preferably 7 to 18 carbon atoms, more preferably 7 to 16 carbon atoms, and even more preferably 8 to 12 carbon atoms), and $Ar^a$ represents an arylene group or a heteroarylene group. Further "*" indicates a bonding site with another structure.

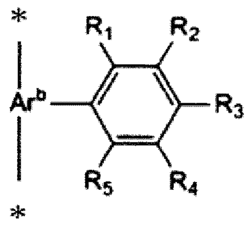

Formula (IIIa)

Each of $R^1$ to $R^5$ in formula (IIIa) independently represents a hydrogen atom or an alkyl group. The alkyl group for $R^1$ to $R^5$ is preferably a linear alkyl group of 6 to 20 carbon atoms (more preferably 7 to 18 carbon atoms, even more preferably 7 to 16 carbon atoms, and still more preferably 8 to 12 carbon atoms). At least one of $R^1$ to $R^5$ is a linear alkyl group of 6 to 20 carbon atoms (preferably 7 to 18 carbon atoms, more preferably 7 to 16 carbon atoms, and even more preferably 8 to 12 carbon atoms), and $Ar^b$ represents an arenetriyl group or a heteroarenetriyl group. Further "*" indicates a bonding site with another structure.

Here, $Ar^a$ may represent, for example, an arylene group or heteroarylene group of 2 to 30 carbon atoms. The arylene group may have a substituent, and the heteroarylene group may have a substituent. Examples of the substituent include the same groups as those mentioned above for E in formulas (1a) to (84a).

Further, $Ar^b$ may represent, for example, an arenetriyl group or heteroarenetriyl group of 2 to 30 carbon atoms. The arenetriyl group may have a substituent, and the heteroarenetriyl group may have a substituent. Examples of the

substituent include the same groups as those mentioned above for E in formulas (1a) to (84a).

Specific examples of $Ar^a$ and $Ar^b$ include the Ar groups, carbazole structures and thiophene structures in formulas (1a) to (93a); the benzene rings in formulas (85a-1) and (86a-1); the arylene groups and heteroarylene groups in formulas (1) to (28); $Ar^1$ and $Ar^2$ in formula (29); W in formula (30); the fluorene structure in formula (31); and Ar in formula (32).

Examples of specific structures having an alkyl chain of 6 to 20 carbon atoms that may be included in the polymer (A) are shown below. In formulas (IV-1) to (IV-8), each of $R^1$ to $R^6$ independently represents a hydrogen atom or an alkyl group. The alkyl group for $R^1$ to $R^8$ is preferably a linear alkyl group of 6 to 20 carbon atoms (more preferably 7 to 18 carbon atoms, even more preferably 7 to 16 carbon atoms, and still more preferably 8 to 12 carbon atoms). At least one of $R^1$ to $R^6$ in formulas (IV-4) and (IV-5), at least one of $R^1$ to $R^5$ in formulas (IV-1) and (IV-2), at least one of $R^1$ to $R^4$ in formulas (IV-6) to (IV-8), and at least one of $R^1$ and $R^2$ in formula (IV-3) is a linear alkyl group of 6 to 20 carbon atoms (preferably 7 to 18 carbon atoms, more preferably 7 to 16 carbon atoms, and even more preferably 8 to 12 carbon atoms). The symbol "*" indicates a bonding site with another structure.

<Specific Structural Examples>

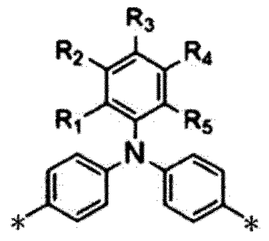

(IV-1)

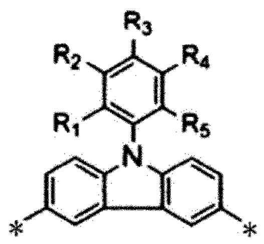

(IV-2)

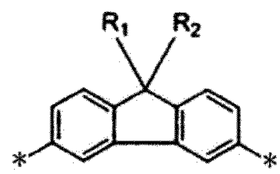

(IV-3)

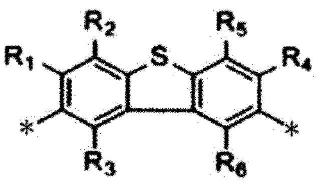

(IV-4)

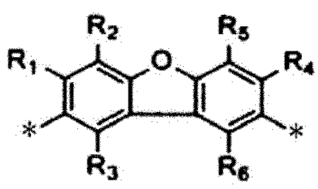

(IV-5)

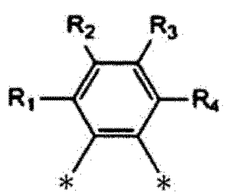

(IV-6)

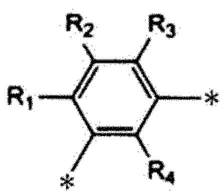

(IV-7)

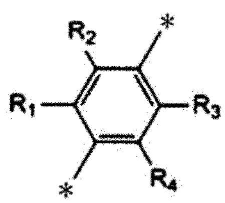

(IV-8)

In those cases where the polymer has an alkyl chain of 6 to 20 carbon atoms as a substituent, the polymer (A) may include a structural unit having the alkyl chain of 6 to 20 carbon atoms as a substituent. Specific examples of structural units having an alkyl chain of 6 to 20 carbon atoms as a substituent include units represented by formulas (1a) to (93a) in which at least one Ar has an alkyl chain of 6 to 20 carbon atoms or a group represented by formula (Ia) as a substituent; units represented by formulas (15a) to (84a) in which at least one E is an alkyl chain of 6 to 20 carbon atoms or a group represented by formula (Ia); units represented by formulas (1) to (28) in which at least one R is an alkyl chain of 6 to 20 carbon atoms or a structure represented by formula (Ia); units represented by formula (29) in which $Ar^1$ and/or $Ar^2$ has an alkyl chain of 6 to 20 carbon atoms or a group represented by formula (Ia) as a substituent; and units represented by formulas (30) to (32) having an alkyl chain of 6 to 20 carbon atoms or a group represented by

formula (Ia) as a substituent.

From the viewpoints of improving the characteristics and enhancing the solvent resistance and the like, the polymer (A) preferably has the alkyl chain of 6 to 20 carbon atoms in a structural unit other than a terminal structural unit.

The polymer (A) preferably has the alkyl chain of 6 to 20 carbon atoms in a divalent structural unit described below. The polymer (A) preferably contains the divalent structural unit having an alkyl chain of 6 to 20 carbon atoms as a structural unit having hole transport properties.

The polymer (A) preferably has a branched structure and preferably has three or more terminals. Ensuring that the polymer (A) has a branched structure is also preferable from viewpoints such as enabling the weight average molecular weight to be increased, enabling the glass transition temperature to be increased, and contributing to an improvement in heat resistance.

Examples of preferred polymers (A) include polymers having a divalent structural unit and a trivalent or higher valent structural unit that constitutes a branched portion described below (for example, a structural unit represented by one of formulas (85a) to (93a) and formulas (30) to (32)), wherein the divalent structural unit has an alkyl chain of 6 to 20 carbon atoms. Polymers (A) having an alkyl chain of 6 to 20 carbon atoms in a divalent structural unit can be obtained, for example, by using a monomer corresponding with one of the specific structural examples described above as one of the monomers used in the polymer synthesis.

(Structure of Polymer (A))

As mentioned above, the polymer (A) may be linear, or may have a branched structure. The polymer (A) preferably contains at least a divalent structural unit L having charge transport properties and a monovalent structural unit T that forms a terminal portion, and may also contain a trivalent or higher valent structural unit B that forms a branched portion. The polymer (A) may contain only one type or a plurality of types of each structural unit. In the polymer (A), the structural units are bonded together at "monovalent" to "trivalent or higher valent" bonding sites. In the following description, a monovalent structural unit is sometimes referred to as a "structural unit T", a divalent structural unit is sometimes referred to as a "structural unit L", and a trivalent or higher valent structural unit is sometimes referred to as a "structural unit B".

In the polymer (A), the structural unit L and/or the structural unit B is preferably a structural unit having hole transport properties, more preferably includes at least one elected from the group consisting of a structural unit containing an aromatic amine structure, a structural unit containing a carbazole structure, a structural unit containing a thiophene structure, a structural unit containing a fluorene structure, and a structural unit containing a furan structure, and more preferably includes at least one selected from the group consisting of a structural unit containing an aromatic amine structure and a structural unit containing a carbazole structure. The aromatic amine structure, carbazole structure, thiophene structure, fluorene structure and furan structure may each be unsubstituted or may have a substituent.

The alkyl chain of 6 to 20 carbon atoms may be incorporated in any of the structural units L, B and T, but is preferably incorporated in one or more of the structural units L and/or B, and is more preferably incorporated in at least a structural unit L. The alkyl chain of 6 to 20 carbon atoms is more preferably incorporated in one or more structural units L and/or B that have hole transport properties, and is even more preferably incorporated in at least a structural unit L having hole transport properties.

The polymer (A) may, for example, be a polymer that does not have a thienyl group which is unsubstituted or substituted with an alkyl group of 1 to 8 carbon atoms, at a terminal, may be a polymer that does not have a thienyl group which is unsubstituted or substituted with an alkyl group of 1 to 10 carbon atoms, at a terminal, may be a polymer that does not have a thienyl group which is unsubstituted or substituted with an alkyl group of 1 to 22 carbon atoms, at a terminal, or may be a polymer that does not have a thienyl group which may have a substituent, at a terminal. The polymer (A) may, for example, be a polymer that does not have a thienyl group which may have a substituent (such as an alkyl group of 1 to 8 carbon atoms, 1 to 10 carbon atoms, or 1 to 22 carbon atoms).

Examples of partial structures contained in the polymer (A) include those shown below. However, the polymer is not limited to polymers having the following partial structures. In the partial structures, "L" represents a structural unit L, "B" represents a structural unit B, and "T" represents a structural unit T. The symbol "*" in the formulas indicates a bonding site with another structural unit. In the following partial structures, the plurality of L structural units may be structural units having the same structure or structural units having mutually different structures. This also applies for the B and T units.

Linear Polymer (A) T-L-L-L-L-L-*

Polymers (A) having Branched Structure

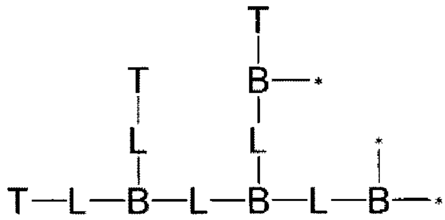

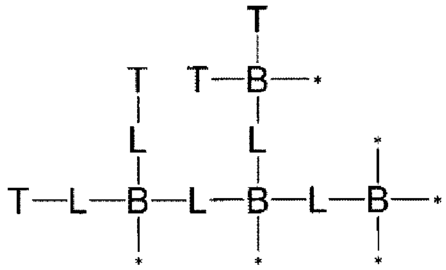

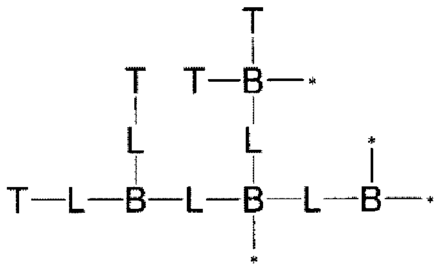

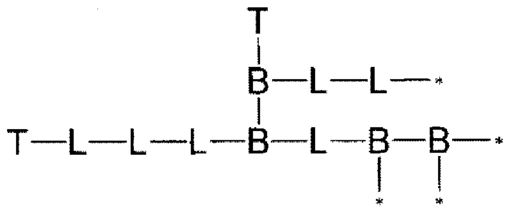

(Structural Unit L)

The structural unit L is a divalent structural unit having charge transport properties. For example, the structural unit L may be selected from among substituted or unsubstituted aromatic amine structures, substituted or unsubstituted carbazole structures, substituted or unsubstituted thiophene structures, substituted or unsubstituted fluorene structures, substituted or unsubstituted benzene structures, substituted or unsubstituted biphenyl structures, substituted or unsubstituted terphenyl structures, substituted or unsubstituted naphthalene structures, substituted or unsubstituted anthracene structures, substituted or unsubstituted tetracene structures, substituted or unsubstituted phenanthrene structures, substituted or unsubstituted dihydrophenanthrene structures, substituted or unsubstituted pyridine structures, substituted or unsubstituted pyrazine structures, substituted or unsubstituted quinoline structures, substituted or unsubstituted isoquinoline structures, substituted or unsubstituted quinoxaline structures, substituted or unsubstituted acridine structures, substituted or unsubstituted diazaphenanthrene structures, substituted or unsubstituted furan structures, substituted or unsubstituted pyrrole structures, substituted or unsubstituted oxazole structures, substituted or unsubstituted oxadiazole structures, substituted or unsubstituted thiazole structures, substituted or unsubstituted thiadiazole structures, substituted or unsubstituted triazole structures, substituted or unsubstituted benzothiophene structures, substituted or unsubstituted benzoxazole structures, substituted or unsubstituted benzoxadiazole structures, substituted or unsubstituted benzothiazole structures, substituted or unsubstituted benzothiadiazole structures, substituted or unsubstituted benzotriazole structures, and structures containing one type, or two or more types, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted aromatic amine structures, substituted or unsubstituted carbazole structures, substituted or unsubstituted thiophene structures, substituted or unsubstituted fluorene structures, substituted or unsubstituted furan structures, substituted or unsubstituted benzene structures, substituted or unsubstituted pyrrole structures, and structures containing one type, or two or more types, of these structures, and is more preferably selected from among substituted or unsubstituted aromatic amine structures, substituted or unsubstituted carbazole structures, and structures containing one type, or two or more types, of these structures. In another embodiment, from the viewpoint of obtaining superior electron transport properties, the structural unit L is preferably selected from among substituted or unsubstituted fluorene structures, substituted or unsubstituted benzene structures, substituted or unsubstituted phenanthrene structures, substituted or unsubstituted pyridine structures, substituted or unsubstituted quinoline structures, and structures containing one type, or two or more types, of these structures. The structural unit L preferably has hole transport properties.

Specific examples of the structural unit L are shown below. However, the structural unit L is not limited to the following structures.

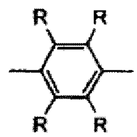 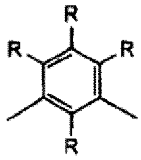 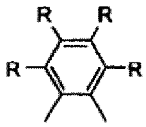 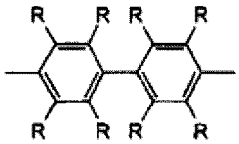 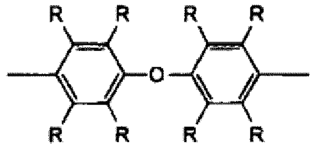

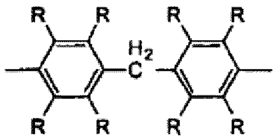 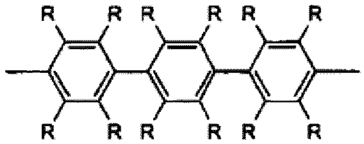 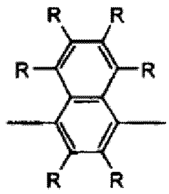 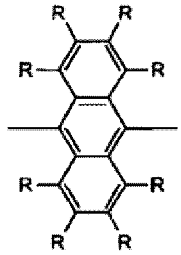

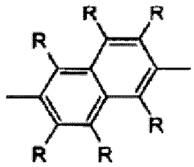 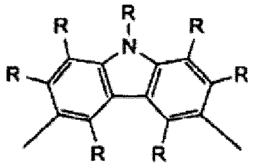 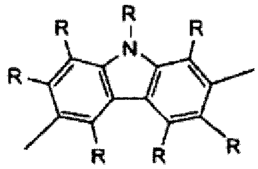 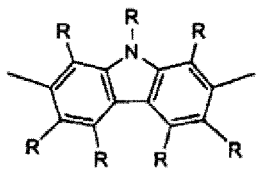

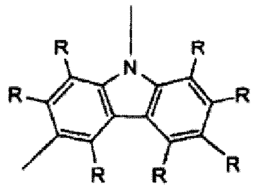 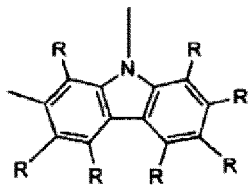 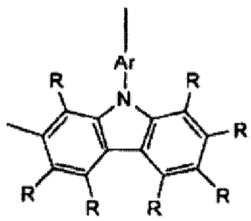 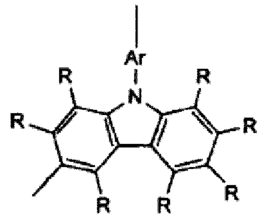

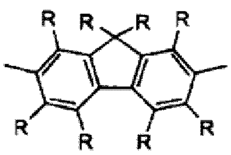 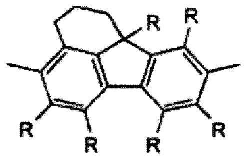 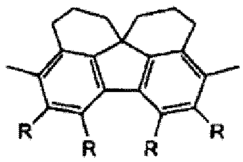 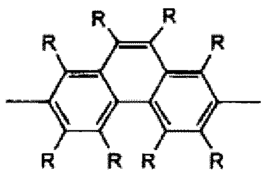

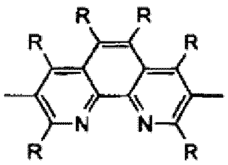 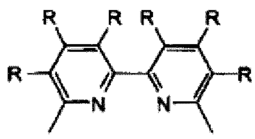 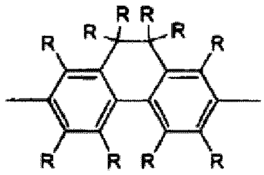 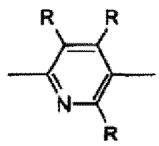

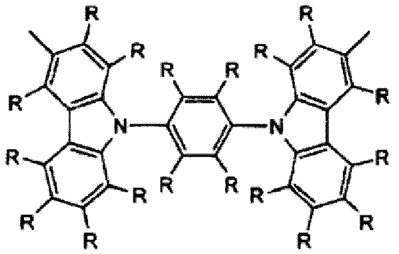 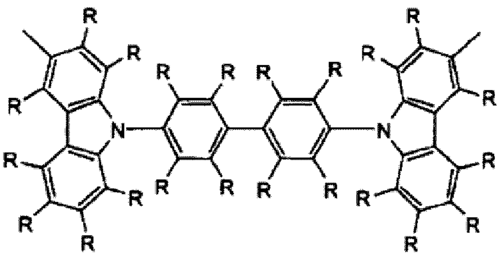

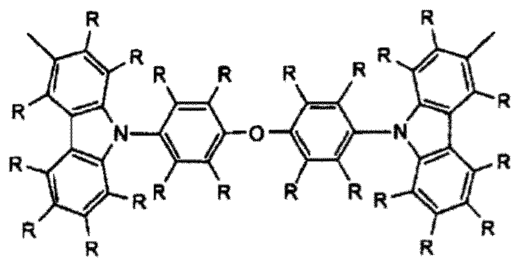

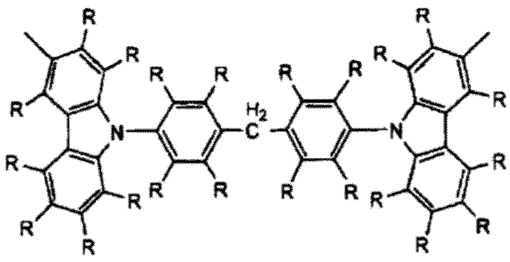

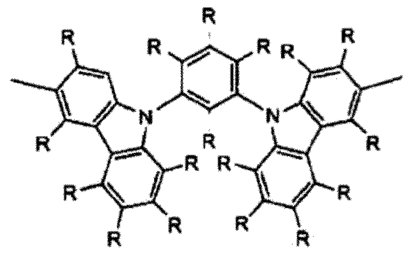

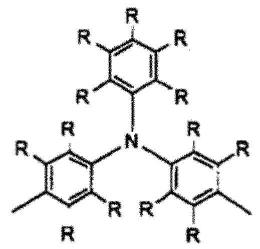

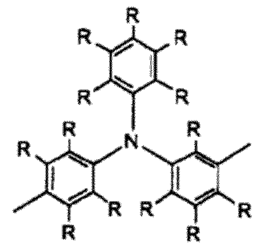

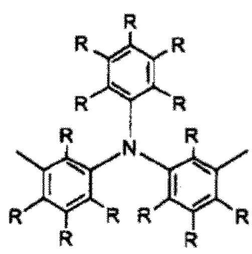

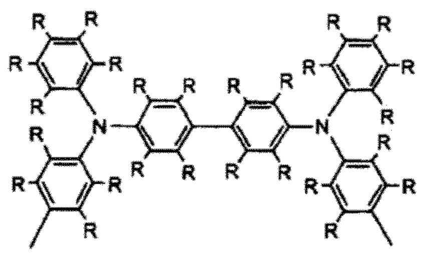

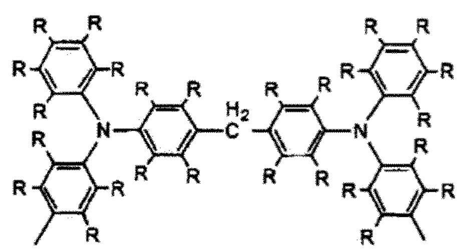

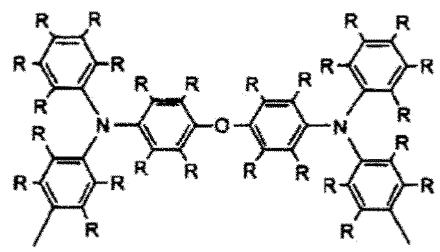

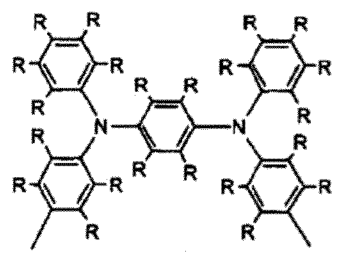

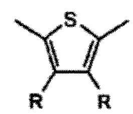

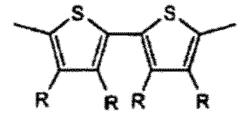

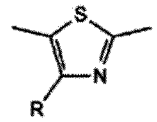

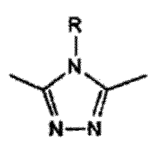

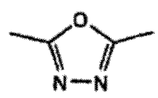

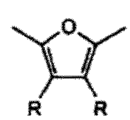

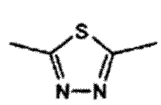

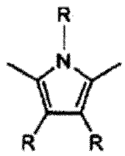
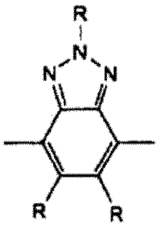
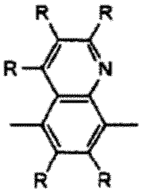
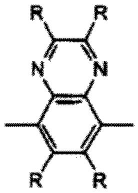
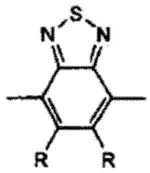
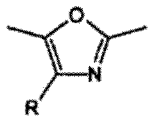
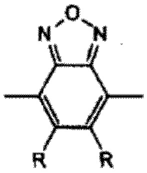
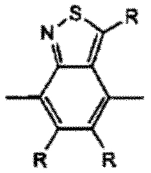
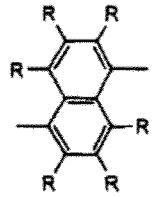

Each R independently represents a hydrogen atom or a substituent. It is preferable that each R is independently selected from a group consisting of $-R^1$, $-OR^2$, $-SR^3$, $-OCOR^4$, $-COOR^5$, $-SiR^6R^7R^8$, halogen atoms, and groups containing a polymerizable functional group described below. Each of $R^1$ to $R^8$ independently represents a hydrogen atom; a linear, cyclic or branched alkyl group of 1 to 22 carbon atoms; or an aryl group or heteroaryl group of 2 to 30 carbon atoms. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. R is preferably a hydrogen atom, an alkyl group, an aryl group, or an alkyl-substituted aryl group. Ar represents an arylene group or heteroarylene group of 2 to 30 carbon atoms. Ar is preferably an arylene group, and is more preferably a phenylene group.

Among the above specific examples, examples of structural units L having an alkyl chain of 6 to 20 carbon atoms include those units in which at least one R is an alkyl chain of 6 to 20 carbon atoms or a structure represented by formula (Ia).

Further, examples of the structural unit L include units represented by the above formulas (1a) to (84a) and (1) to (29).

(Structural Unit T)

The structural unit T is a monovalent structural unit that forms a terminal portion of the polymer (A).

There are no particular limitations on the structural unit T. The structural unit T may be, for example, selected from among substituted or unsubstituted aromatic hydrocarbon structures, substituted or unsubstituted aromatic heterocyclic structures, and structures containing one type, or two or more types, of these structures. A structure other than a thiophene structure is preferred as the aromatic heterocyclic structure.

In one embodiment, from the viewpoint of imparting durability without impairing the charge transport properties, the structural unit T is preferably a substituted or unsubstituted aromatic hydrocarbon structure, and is more preferably a substituted or unsubstituted benzene structure. Further, in another embodiment, when the polymer (A) has a polymerizable functional group at a terminal portion in the manner described below, the structural unit T may be a polymerizable structure (for example, a polymerizable functional group such as a pyrrolyl group).

The structural unit T may have the same structure as the structural unit L, or may have a different structure.

Specific examples of the structural unit T includes a structure shown below. However, the structural unit T is not limited to the structure below.

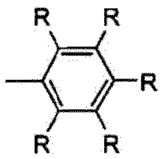

R is the same as R described in relation to the structural unit L. Examples of the structural unit T in those cases where the structural unit T has an alkyl chain of 6 to 20 carbon atoms include structures in which at least one R is an alkyl chain of 6 to 20 carbon atoms. In those cases where the polymer (A) has a polymerizable functional group described below at a terminal portion, it is preferable that at least one R is a group containing a polymerizable functional group.

(Structural Unit B)

The structural unit B is a trivalent or higher valent structural unit that forms a branched portion in those cases where the polymer (A) has a branched structure. From the viewpoint of improving the durability of organic electronic elements, the structural unit B is preferably not higher than hexavalent, and is more preferably either trivalent or tetravalent. The structural unit B is preferably a unit that has charge transport properties, and more preferably has hole transport properties. The structural unit B may, for example, be selected from among substituted or unsubstituted aromatic amine structures, substituted or unsubstituted carbazole structures, substituted or unsubstituted thiophene structures, substituted or unsubstituted fluorene structures, substituted or unsubstituted furan structures, and structures containing one type, or two or more types, of these structures. For example, from the viewpoint of improving the durability of organic electronic elements, the structural unit B is preferably selected from among substituted or unsubstituted aromatic amine structures, substituted or unsubstituted carbazole structures, substituted or unsubstituted condensed polycyclic aromatic hydrocarbon structures, and structures containing one type, or two or more types, of these structures. The structural unit B may have the same structure as the structural unit L, or may have a different structure. The structural unit B may have the same structure as the structural unit T, or may have a different structure.

Specific examples of the structural unit B includes the structures shown below. However, the structural unit B is not limited to the following structures.

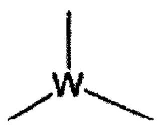
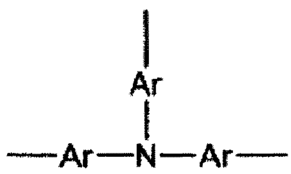
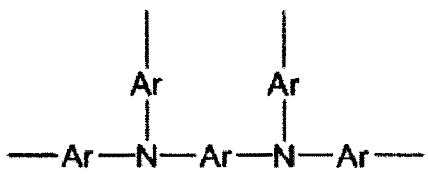
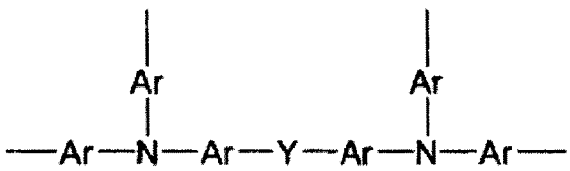
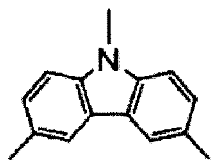
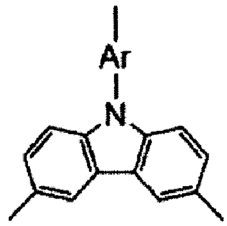
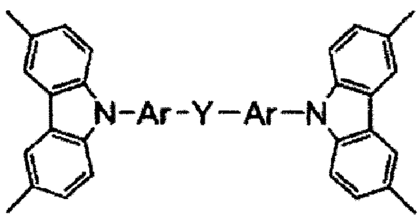
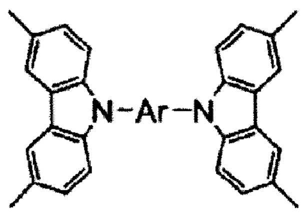
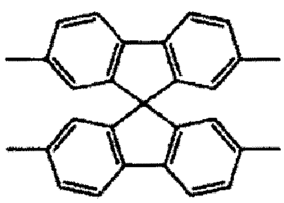
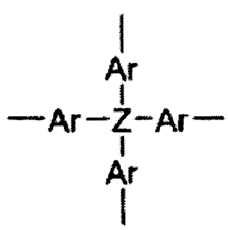
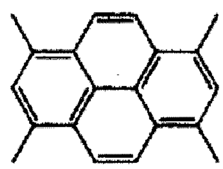

W represents a trivalent linking group, and, for example, may represent an arenetriyl group or heteroarenetriyl group of 2 to 30 carbon atoms. As described above, an arenetriyl group is an atom grouping in which three hydrogen atoms have been removed from an aromatic hydrocarbon. A heteroarenetriyl group is an atom grouping in which three hydrogen atoms have been removed from an aromatic heterocycle. Each Ar independently represents a divalent linking group, and for example, may represent an arylene group or heteroarylene group of 2 to 30 carbon atoms. Ar is preferably an arylene group, and more preferably a phenylene group. Y represents a divalent linking group, and examples thereof include divalent groups in which an additional hydrogen atom has been removed from any of the R groups having one

or more hydrogen atoms (but excluding groups containing a polymerizable functional group) described in relation to the structural unit L. Z represents a carbon atom, a silicon atom or a phosphorus atom. In the structural units, W, the benzene rings and the Ar groups may each have a substituent, and examples of the substituent include the R groups in the structural unit L.

Examples of structural units B having an alkyl chain of 6 to 20 carbon atoms include any of the above units in which one of W, a benzene ring or an Ar group has an alkyl chain of 6 to 20 carbon atoms or a structure represented by formula (Ia) as a substituent.

Examples of the structural unit B include units represented by the above formulas (85a) to (93a) and (1) to (32).

(Polymerizable Functional Group)

From the viewpoint of enabling the polymer to be cured by a polymerization reaction, thereby changing the degree of solubility in solvents, the polymer (A) preferably has at least one polymerizable functional group (also referred to as a "polymerizable substituent"). A "polymerizable functional group" is a group which is able to form a bond (bonds) upon the application of heat and/or light.

Examples of the polymerizable functional group include groups having a carbon-carbon multiple bond (such as a vinyl group, an allyl group, a butenyl group, an ethynyl group, an acryloyl group, an acryloyloxy group, an acryloylamino group, a methacryloyl group, a methacryloyloxy group, a methacryloylamino group, a vinyloxy group and a vinylamino group), groups having a small ring (including cyclic alkyl groups such as a cyclopropyl group and a cyclobutyl group; cyclic ether groups such as an epoxy group (an oxiranyl group) and an oxetane group (an oxetanyl group); diketene groups; episulfide groups; lactone groups; and lactam groups); and heterocyclic groups (such as a furanyl group, a pyrrolyl group, a thiophenyl group and a silolyl group). Particularly preferred polymerizable functional groups include a vinyl group, an acryloyl group, a methacryloyl group, an epoxy group and an oxetane group, and from the viewpoints of the reactivity and the characteristics of the organic electronic elements, a vinyl group, an oxetane group or an epoxy group is more preferred, and an oxetane group is the most desirable. These groups may be substituted, and although there are no particular limitations on the substituent in the case of a substituted group, examples of the substituent include linear, cyclic or branched alkyl groups of 1 to 22 carbon atoms (and more preferably 1 to 10 carbon atoms).

From the viewpoints of increasing the degree of freedom associated with the polymerizable functional group and facilitating the polymerization reaction, the main backbone of the polymer (A) and the polymerizable functional group are preferably linked, for example, via a linear alkylene chain of 1 to 8 carbon atoms. In the case where, for example, the organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. From the viewpoint of simplifying preparation of the monomer used for introducing the polymerizable functional group, the polymer (A) may have an ether linkage or an ester linkage at the terminal portion of the alkylene chain and/or the hydrophilic chain, namely, at the linkage site between such a chain and the polymerizable functional group, and/or at the linkage site between such a chain and the backbone of the polymer (A). The aforementioned "group containing a polymerizable functional group" means either a polymerizable functional group itself, or a group composed of a combination of a polymerizable functional group and an alkylene chain or the like. Examples of groups containing a polymerizable functional group that can be used favorably include groups exemplified in WO2010/140553.

The polymerizable functional group may be introduced at a terminal portion of the polymer (A) (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the polymer (A) has a branched structure, the polymerizable functional group may be introduced within the main chain of the polymer (A), within a side chain, or within both the main chain and side chain.

From the viewpoint of contributing to a change in the degree of solubility, the polymerizable functional group is preferably included in a large amount within the polymer (A). On the other hand, from the viewpoint of not impeding the charge transport properties, the amount included in the polymer (A) is preferably kept small. The amount of the polymerizable functional group may be set as appropriate with due consideration of these factors.

For example, from the viewpoint of obtaining a satisfactory change in the degree of solubility, the number of polymerizable functional groups per molecule of the polymer (A) is preferably at least 2, and more preferably 3 or greater. Further, from the viewpoint of maintaining favorable charge transport properties, the number of polymerizable functional groups is preferably not more than 1,000, and more preferably 500 or fewer.

The number of polymerizable functional groups per molecule of the polymer (A) can be determined as an average value, using the amount of the polymerizable functional group used in synthesizing the polymer (A) (for example,

the amount added of the monomer having the polymerizable functional group), the amounts added of the monomers corresponding with the various structural units, and the weight average molecular weight of the polymer (A) and the like. Further, the number of polymerizable functional groups can also be calculated as an average value using the ratio between the integral of the signal attributable to the polymerizable functional group and the integral of the total spectrum in the $^{1}$H-NMR (nuclear magnetic resonance) spectrum of the polymer (A), and the weight average molecular weight of the polymer (A) and the like. In terms of simplicity, if the amounts added of the various components are clear, then the value determined using these amounts is preferably employed.

From the viewpoints of suppressing crystallization and obtaining favorable film formability, the weight average molecular weight of the polymer (A) is preferably at least 1,000, more preferably at least 2,000, and even more preferably 3,000 or greater. Further, from the viewpoints of improving the degree of solubility in solvents and facilitating the preparation of compositions containing the solvent described below, the weight average molecular weight of the polymer (A) is preferably not more than 1,000,000, more preferably not more than 900,000, and even more preferably 800,000 or less. The "weight average molecular weight" refers to the weight average molecular weight referenced against standard polystyrenes and determined by gel permeation chromatography (GPC).

More specifically, the weight average molecular weight of the polymer is preferably within a range from 1,000 to 1,000,000, more preferably from 2,000 to 900,000, and even more preferably from 3,000 to 800,000.

From the viewpoint of obtaining favorable film formation stability, the average value for the number of structural units in the polymer (A) is preferably at least 2, more preferably at least 5, and even more preferably 10 or greater. Further, from the viewpoint of adequately changing the degree of solubility of the organic electronic material, thereby enabling ready stacking of the organic layers, the average value for the number of structural units is preferably not more than 1,000, more preferably not more than 500, and even more preferably 200 or fewer. The "average value for the number of structural units" can be determined from the weight average molecular weight of the polymer (A), the molecular weights of the various structural units, and the proportions of those structural units within the polymer (A). Further, the "proportion of a structural unit" can be determined from the blend ratio (molar ratio) of the monomer corresponding with the structural unit that is used in synthesizing the polymer (A).

More specifically, the average value for the number of structural units in the polymer (A) is preferably within a range from 2 to 1,000, more preferably from 5 to 500, and even more preferably from 10 to 200.

Further, from the viewpoint of obtaining superior hole transport properties, the ratio of structural units L having hole transport properties and structural units B having hole transport properties (for example, structural units represented by formulas (1a) to (93a)), relative to the total of all the structural units in the polymer (A), is preferably at least 10 mol%, more preferably at least 25 mol%, and even more preferably 50 mol% or greater. Furthermore, this ratio of structural units L having hole transport properties and structural units B having hole transport properties (for example, structural units represented by formulas (1a) to (93a)) is preferably not more than 95 mol%, more preferably not more than 90 mol%, and even more preferably 80 mol% or less.

More specifically, the ratio of structural units L having hole transport properties and structural units B having hole transport properties (for example, structural units represented by formulas (1a) to (93a)), relative to the total of all the structural units in the polymer (A), is preferably within a range from 10 to 95%, more preferably from 25 to 90%, and even more preferably from 50 to 80%.

From the viewpoint of obtaining satisfactory charge transport properties, the ratio of the structural unit L relative to the total of all the structural units in the polymer (A) is preferably at least 10 mol%, more preferably at least 20 mol%, and even more preferably 30 mol% or greater. If consideration is given to the introduction of the structural unit T and the optionally introduced structural unit B, then the ratio of the structural unit L is preferably not more than 95 mol%, more preferably not more than 90 mol%, even more preferably not more than 85 mol%, still more preferably not more than 80 mol%, and still more preferably 75 mol% or less.

From the viewpoint of improving the characteristics of organic electronic elements, or from the viewpoint of suppressing any increase in viscosity and facilitating the synthesis of the charge transport polymer, the ratio of the structural unit T contained in the polymer (A), based on the total of all the structural units, is preferably at least 5 mol%, more preferably at least 10 mol%, and even more preferably 15 mol% or greater. From the viewpoint of obtaining satisfactory charge transport properties, the ratio of the structural unit T is preferably not more than 60 mol%, more preferably not more than 55 mol%, and even more preferably 50 mol% or less.

In those cases where the polymer (A) has a branched structure, from the viewpoint of increasing the number of terminals and increasing the change in the degree of solubility, the ratio of the structural unit B (for example, structural units represented by formulas (85a) to (93a) and formulas (30) to (32)) relative to the total of all the structural units in the polymer (A) is preferably at least 1 mol%, more preferably at least 3 mol%, and even more preferably 10 mol% or greater. Furthermore, from the viewpoint of preventing synthesis problems caused by gelling during synthesis of the polymer (A), the ratio of the structural unit B (for example, structural units represented by any of formulas (85a) to (93a) and formulas (30) to (32)) is preferably not more than 50 mol%, more preferably not more than 30 mol%, and even more preferably 25 mol% or less.

More specifically, the ratio of the structural unit B (for example, structural units represented by formulas (85a) to (93a) and formulas (30) to (32)) relative to the total of all the structural units in the polymer (A) is preferably within a range from 1 to 50 mol%, more preferably from 3 to 30 mol%, and even more preferably from 10 to 25 mol%.

In those cases where the structural units T of the polymer (A) include a structural unit having a polymerizable functional group, from the viewpoints of improving the emission efficiency and improving the emission lifespan, the proportion of structural units T having a polymerizable functional group among all of the structural units T of the polymer (A) is preferably not more than 50 mol%, more preferably not more than 40 mol%, even more preferably not more than 30 mol%, still more preferably not more than 25 mol%, and still more preferably 20 mol% or less. The proportion of structural units T having a polymerizable functional group among all of the structural units T of the polymer (A) may be at least 1 mol%, at least 3 mol%, at least 5 mol%, or 10 mol% or greater.

From the viewpoint of the solvent resistance, the ratio of alkyl chains of 6 to 20 carbon atoms relative to the total of all the structural units in the polymer (A) is preferably at least 20 mol%, more preferably at least 30 mol%, even more preferably at least 40 mol%, and still more preferably 50 mol% or greater. The ratio of alkyl chains of 6 to 20 carbon atoms relative to the total of all the structural units in the polymer (A) may be, for example, 90 mol% or less. This "ratio of alkyl chains of 6 to 20 carbon atoms" is the ratio of structural units having an alkyl chain of 6 to 20 carbon atoms. In those cases where the structural units L of the polymer (A) include a structural unit having an alkyl chain of 6 to 20 carbon atoms, the proportion of the structural unit L having an alkyl chain of 6 to 20 carbon atoms among all of the structural units L in the polymer (A) is, for example, preferably at least 20 mol%, more preferably at least 40 mol%, and even more preferably 60 mol% or greater. Further, the proportion of the structural unit L having an alkyl chain of 6 to 20 carbon atoms among all of the structural units L in the polymer (A) may be, for example, not more than 100 mol%, not more than 95 mol%, or 90 mol% or less.

The proportion of each structural unit can be determined using the blend amount of the monomer corresponding with that structural unit used in synthesizing the polymer (A). Further, the proportion of each structural unit can also be calculated as an average value using the integral of the spectrum attributable to the structural unit in the $^1$H-NMR spectrum of the polymer (A). In terms of simplicity, if the blend amounts of the various components are clear, then the value determined using these amounts is preferably employed.

The polymer (A) can be produced using various synthesis methods well known to those in the art. For example, in those cases where each of the monomer units used in the synthesis of the polymer (A) has an aromatic ring, and the polymer (A) is produced by bonding those aromatic rings together, methods that can be used include those disclosed by T. Yamamoto et al., Bull. Chem. Soc. Jpn., vol. 51, No. 7, page 2091 (1978), M. Zembayashi et al., Tet. Lett., vol. 47, page 4089 (1977), and A. Suzuki, Synthetic Communications, vol. 11, No. 7, page 513 (1981). In particular, the method described by A. Suzuki is typical for the production of the polymer (A). Monomer units corresponding with each of the structural units described above can be used as the various monomer units.

The method disclosed by A. Suzuki is a method of initiating a cross-coupling reaction (commonly called the "Suzuki reaction") between an aromatic boronic acid derivative and an aromatic halide using a Pd catalyst. By using the desired aromatic rings in the coupling reaction, the polymer (A) can be produced.

Further, in the Suzuki reaction, a soluble Pd compound such as a Pd(II) salt or a Pd(0) complex is typically used as the Pd catalyst. Examples of preferred Pd sources include $Pd(Ph_3P)_4$, a $Pd(OAc)_2$ complex with a tertiary phosphine ligand, a $Pd_2(dba)_3$ complex and a $PdCl_2(dppf)$ complex, which can be used in an amount of 0.01 to 5 mol% relative to the amount of aromatic reactants.

In this reaction, a base is typically also used, and the base is preferably an aqueous alkali carbonate or bicarbonate, or a tetraalkylammonium hydroxide. A phase transfer catalyst may be used to promote the reaction in a non-polar solvent. Examples of solvents that may be used include N,N-dimethylformamide, toluene, anisole, dimethoxyethane and tetrahydrofuran.

[Initiator]

From the viewpoint of changing the degree of solubility of the organic electronic material, the organic electronic material preferably also contains an initiator. A substance that can function as an oxidizing agent within the organic electronic material can be used as the initiator. The use of a substance that can function as an oxidizing agent of the polymer (A) is preferred from the viewpoint of improving the hole transport properties. An onium salt including a cation and an anion is preferred as the initiator from the viewpoint of changing the degree of solubility of the composition, and details of such onium salts are described below.

(Cation)

Examples of the cation include $H^+$, a carbenium ion, an ammonium ion, an anilinium ion, a pyridinium ion, an imidazolium ion, a pyrrolidinium ion, a quinolinium ion, an imonium ion, an aminium ion, an oxonium ion, a pyrylium ion,

a chromenylium ion, a xanthylium ion, an iodonium ion, a sulfonium ion, a phosphonium ion, a tropylium ion and cations having a transition metal, and of these, a carbenium ion, an ammonium ion, an anilinium ion, an aminium ion, an iodonium ion, a sulfonium ion or a tropylium ion is preferred. From the viewpoint of achieving a favorable combination of solvent resistance and storage stability, an ammonium ion, an anilinium ion, an iodonium ion or a sulfonium ion is more preferable.

(Anion)

Examples of the anion include halogen ions such as $F^-$, $Cl^-$, $Br^-$ and $I^-$; $OH^-$; $ClO_4^-$; sulfonate ions such as $FSO_3^-$, $ClSO_3^-$, $CH_3SO_3^-$, $C_6H_5SO_3^-$ and $CF_3SO_3^-$; sulfate ions such as $HSO_4^-$ and $SO_4^{2-}$; carbonate ions such as $HCO_3^-$ and $CO_3^{2-}$; phosphate ions such as $H_2PO_4^-$, $HPO_4^{2-}$ and $PO_4^{3-}$; fluorophosphate ions such as $PF_6^-$ and $PF_5OH^-$; fluoroalkyl fluorophosphate ions such as $[(CF_3CF_2)_3PF_3]^-$, $[(CF_3CF_2CF_2)_3PF_3]^-$, $[((CF_3)_2CF)_3PF_3]^-$, $[((CF_3)_2CF)_2PF_4]^-$, $[((CF_3)_2CFCF_2)_3PF_3]^-$ and $[((CF_3)_2CFCF_2)_2PF_4]^-$; fluoroalkane sulfonyl methide ions or fluoroalkane sulfonyl imide ions such as $(CF_3SO_2)_3C^-$ and $(CF_3SO_2)_2N^-$; borate ions such as $BF_4^-$, $B(C_6H_5)_4^-$ and $B(C_6H_4CF_3)_4^-$; fluoroantimonate ions such as $SbF_6^-$ and $SbF_5OH^-$; fluoroarsenate ions such as $AsF_6^-$ and $AsF_5OH^-$; as well as $AlCl_4^-$ and $BiF_6^-$. Among these, from the viewpoint of the solvent resistance achieved when used in combination with the cation described above, fluorophosphate ions such as $PF_6^-$ and $PF_5OH^-$; fluoroalkyl fluorophosphate ions such as $[(CF_3CF_2)_3PF_3]^-$, $[(CF_3CF_2CF_2)_3PF_3]^-$, $[((CF_3)_2CF)_3PF_3]^-$, $[((CF_3)_2CF)_2PF_4]^-$, $[((CF_3)_2CFCF_2)_3PF_3]^-$ and $[((CF_3)_2CFCF_2)_2PF_4]^-$; fluoroalkane sulfonyl methide ions or fluoroalkane sulfonyl imide ions such as $(CF_3SO2)_3C^-$ and $(CF_3SO_2)_2N^-$; borate ions such as $BF_4^-$, $B(C_6H_5)_4^-$ and $B(C_6H_4CF_3)_4^-$; and fluoroantimonate ions such as $SbF_6^-$ and $SbF_5OH^-$ are preferred, and borate ions are particularly desirable.

More specifically, an initiator containing at least one cation selected from among an ammonium ion, anilinium ion, iodonium ion and sulfonium ion, and at least one anion selected from among fluorophosphate ions, fluoroalkyl fluorophosphate ions, fluoroalkane sulfonyl methide ions, fluoroalkane sulfonyl imide ions, borate ions and fluoroantimonate ions is preferred. However, specific examples of the anions and cations that may be included in these preferred initiators are not limited to the above ions, and known anions and cations may be used.

From the viewpoint of changing the degree of solubility of the organic electronic material and facilitating multilayering, the amount of the initiator, relative to the mass of the polymer (A), is preferably at least 0.1% by mass, more preferably at least 0.2% by mass, and even more preferably 0.5% by mass or greater. From the viewpoint of preventing any deterioration in element characteristics caused by substances derived from residual initiator in the organic layer, the amount of the initiator is preferably not more than 30% by mass, more preferably not more than 25% by mass, and even more preferably 20% by mass or less. Examples of these substances derived from the initiator include the initiator itself, as well as decomposition products and reaction products of the initiator.

More specifically, the amount of the initiator, relative to the mass of the polymer (A), is preferably within a range from 0.1 to 30% by mass, more preferably within a range from 0.2 to 25% by mass, and particularly preferably within a range from 0.5 to 20% by mass.

The degree of solubility of the organic electronic material can be changed by light irradiation and/or heating, and therefore multi-layering by coating can be performed even using the same solvent. For the light irradiation, for example, light with a wavelength within a range from 200 to 800 nm can be used. The heating temperature is preferably within a range from 60 to 300°C, more preferably from 80 to 250°C, and even more preferably from 100 to 220°C. The heating time is preferably within a range from 10 seconds to 2 hours, more preferably from 1 minute to 1 hour, and even more preferably from 1 to 10 minutes.

[Solvent (C)]

The organic electronic material may also contain a solvent. Any solvent that enables the organic electronic material to be used to form a coating layer may be used, and the use of a solvent that is capable of dissolving the polymer (A) and the initiator is preferable.

Examples of the solvent include water; alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amides such as N,N-dimethylformamide and N,N-dimethylacetamide; as well as dimethyl sulfoxide, tetrahydrofuran, acetone, chloroform and methylene chloride. Aromatic hydrocarbons, aliphatic esters, aromatic esters, aliphatic ethers and aromatic ethers are preferred.

The amount of the solvent in the organic electronic material can be determined with due consideration of the

use of the material in various coating methods. For example, the amount of the solvent is preferably an amount that yields a ratio of the polymer (A) relative to the solvent that is at least 0.1% by mass, more preferably at least 0.2% by mass, and even more preferably 0.5% by mass or greater. The amount of the solvent is preferably an amount that yields a ratio of the polymer (A) relative to the solvent that is not more than 10% by mass, more preferably not more than 5% by mass, and even more preferably 3% by mass or less.

More specifically, the amount of the solvent in the organic electronic material is preferably an amount that yields a ratio of the polymer (A) relative to the solvent that is within a range from 0.1 to 10% by mass, more preferably from 0.2 to 5% by mass, and even more preferably from 0.5 to 3% by mass.

The mechanism by which the degree of solubility of the organic electronic material changes is not entirely clear, but in an example of one possible mechanism, it is thought that the alkyl chains of 6 to 20 carbon atoms become intertwined, for example as a result of the alkyl chains forming an intertwined structure under the action of light and/or heat and the initiator, thus causing a change in the degree of solubility. The polymer (A) may have a group capable of forming a bond, such as a carbon-carbon double bond group or a group having a small ring. In one embodiment, the organic electronic material can be used as a curable resin composition.

When forming multiple organic layers, the size of the change in the degree of solubility of the organic electronic material in solvents is preferably as large as possible. Confirmation as to whether or not "the degree of solubility of the organic electronic material changes" can be made by ascertaining whether or not the degree of solubility in solvents of an organic layer formed using the composition changes upon the application of light and/or heat. Specifically, first, a composition containing the polymer (A), the initiator (B) and a solvent (1) is used to form an organic layer (1) by a coating method. Following an optional drying step, light and/or heat is applied to the organic layer (1), thus obtaining an organic layer (2). Subsequently, the organic layer (2) is brought into contact with a solvent (2), thus obtaining an organic layer (3). It can be stated that the larger the thickness of the organic layer (3), the greater the size of the change in the degree of solubility of the composition. In other words, the ratio of the thickness of the organic layer (3) relative to the thickness of the organic layer (2) (namely, the residual ratio of the organic layer) is preferably large. Specifically, the residual ratio is preferably at least 50%, more preferably at least 80%, and even more preferably 90% or greater. The residual ratio can be determined from the ratio between the thickness measurement values for the organic layer (2) and the organic layer (3), or from the ratio between the absorbance measurement values for the organic layer (2) and the organic layer (3).

At this time, the thickness of the organic layer (2) is preferably the same as the thickness of the organic layer described below that represents an embodiment of the present invention. The solvent (2) may be the same solvent as the solvent (1), or the solvent that has the largest weight ratio within the solvent (1) in those cases where the solvent (1) is a mixed solvent, or alternatively, toluene may be used. In the confirmation uses the solvent (1), the solvent that has the largest weight ratio within the solvent (1), or toluene, the thickness of the organic layer (3) is preferably at least as large as the thickness described above. Confirmation using either the solvent that has the largest weight ratio within the solvent (1) or toluene is preferred, and the use of toluene is particularly simple.

Because the organic electronic material contains the polymer (A) which, as described above, has a structural unit having hole transport properties, the organic electronic material can be used favorably as a hole transport material composition used in forming an organic electronic element such as an organic EL element or an organic photoelectric conversion element or the like.

<Ink Composition>

Further, one embodiment of the present invention relates to an ink composition containing the organic electronic material described above.

The ink composition may contain the polymer (A), and may generally contain a solvent capable of dissolving or dispersing the polymer (A). The ink composition preferably contains, the polymer (A), an initiator, and a solvent capable of dissolving or dispersing these components. Examples of the solvent are as described above.

[Additives]

The ink composition may also contain one or more additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

[Contents]

The amount of the solvent in the ink composition can be determined with due consideration of the use of the composition in various coating methods. For example, the amount of the solvent is preferably an amount that yields a

ratio of the polymer (A) relative to the solvent that is at least 0.1% by mass, more preferably at least 0.2% by mass, and even more preferably 0.5% by mass or greater. The amount of the solvent is preferably an amount that yields a ratio of the polymer (A) relative to the solvent that is not more than 20% by mass, more preferably not more than 15% by mass, and even more preferably 10% by mass or less.

<Organic Layer>

Furthermore, another embodiment of the present invention relates to an organic layer formed using the organic electronic material or the ink composition described above. The organic layer can be obtained, for example, by applying heat, light, or a combination of both heat and light, to a layer formed by applying one of these compositions, thereby obtaining an organic layer having a different degree of solubility to that prior to the application of heat and/or light.
Examples of the coating method include conventional methods, including inkjet methods, casting methods, dipping methods, printing methods such as relief printing, intaglio printing, offset printing, lithographic printing, letterpress inversion offset printing, screen printing and gravure printing, and spin coating methods. The coating is typically performed at a temperature within a range from -20 to +300°C, preferably from 10 to 100°C, and particularly preferably from 15 to 50°C. Further, following coating, the obtained organic layer may be dried on a hotplate or in an oven to remove the solvent, typically at a temperature within a range from +30 to +300°C, preferably from 60 to 250°C, and particularly preferably from 80 to 220°C. The drying time is typically from 10 seconds to 2 hours, preferably from 1 minute to 1 hour, and particularly preferably from 1 to 10 minutes.
By applying heat, light, or a combination of both heat and light, to the organic layer formed by the coating method, an organic layer having a degree of solubility different from that prior to the application of heat and/or light can be obtained. The conditions for applying the light and/or heat (the light irradiation and/or heating conditions) are as described above. Because the resulting organic layer exhibits only low solubility in solvents, another organic layer can be easily formed on top of the organic layer using a coating solution. The solvent contained in the coating solution used in forming the other organic layer is not limited to the solvent (2) described above.
The light irradiation can be performed using a light source such as a low-pressure mercury lamp, medium-pressure mercury lamp, high-pressure mercury lamp, ultra high-pressure mercury lamp, metal halide lamp, xenon lamp, fluorescent lamp, light-emitting diode or sunlight. The heating can be performed on a hot plate or in an oven.
The thickness of the organic layer can be set appropriately in accordance with the intended application. For example, the thickness can be set within a range from 5 nm to 10 μm. Particularly in those cases when the organic layer is used for a hole injection layer and/or a hole transport layer of an organic EL element, from the viewpoint of moderating surface roughness on the anode and reducing the chance of short-circuits, the thickness of the organic layer is preferably at least 5 nm, more preferably at least 10 nm, and even more preferably 20 nm or greater, both before and after the change in the degree of solubility. From the viewpoint of reducing the drive voltage of the organic EL element, the thickness of the organic layer is preferably not more than 500 nm, more preferably not more than 200 nm, and even more preferably 100 nm or less. Specifically, the thickness is preferably within a range from 5 to 500 nm, more preferably from 10 to 200 nm, and even more preferably from 20 to 100 nm.

[Organic Electronic Element, Display Element, Illumination Device]

Further, embodiments of the present invention relate to organic electronic elements such as an organic EL element and an organic photoelectric conversion element that have the organic layer described above. The organic electronic element contains at least two electrodes, and has the organic layer positioned between the electrodes. Moreover, other embodiments of the present invention relate to a display element and an illumination device that use the organic EL element.

[Organic Electroluminescent Element (Organic EL Element)]

The organic EL element according to one embodiment of the present invention contains the organic layer described above. The organic EL element typically contains a light-emitting layer, an anode, a cathode and a substrate, and may also contain one or more other layers such as a hole injection layer, electron injection layer, hole transport layer or electron transport layer. The organic EL element has at least the organic layer described above, and for example, the organic layer can be used as the light-emitting layer or as another layer, and is preferably used as a hole injection layer and/or a hole transport layer. Accordingly, one example of the organic EL element has, in sequence, an anode, the organic layer which functions as a hole injection layer and/or a hole transport layer, a light-emitting layer and a cathode, and may also include one or more other optional layers between these layers.
FIG. 1 is a cross-sectional schematic view illustrating one embodiment of the organic EL element. The organic EL element in FIG. 1 is an element with a multilayer structure, and has a substrate 8, an anode 2, a hole injection layer

3, a hole transport layer 6, a light-emitting layer 1, an electron transport layer 7, an electron injection layer 5 and a cathode 4 provided in that order.

Each of these layers is described below.

[Light-Emitting Layer]

The material used for the light-emitting layer may be a low-molecular weight compound, or a polymer or oligomer, and a dendrimer or the like may also be used. Examples of low-molecular weight compounds for utilizing fluorescence include perylene, coumarin, rubrene, quinacridone, dyes for dye lasers (such as rhodamine and DCM1), aluminum complexes (such as tris(8-hydroxyquinolinato)aluminum(III) ($Alq_3$)), stilbene, and derivatives of these compounds. Examples of polymers or oligomers for utilizing fluorescence include polyfluorene, polyphenylene, polyphenylene vinylene (PPV), polyvinylcarbazole (PVK), fluorene-benzothiadiazole copolymers, fluorene-triphenylamine copolymers, and derivatives and mixtures and the like thereof.

On the other hand, in recent years, the development of phosphorescent organic EL elements is also being actively pursued, with the aim of increasing the efficiency of organic EL elements. In a phosphorescent organic EL element, not only the energy from a singlet state, but also the energy from a triplet state can be utilized, and the internal quantum yield can be raised to 100% in principle. In a phosphorescent organic EL element, a metal complex-based phosphorescent material containing a heavy metal such as platinum or iridium is used as a phosphorescence-generating dopant for doping the host material, thus enabling the extraction of phosphorescent emission (see M.A. Baldo et al., Nature, vol. 395, page 151 (1998), M.A. Baldo et al., Applied Physics Letters, vol. 75, page 4 (1999), and M.A. Baldo et al., Nature, vol. 403, page 750 (2000)).

In the organic EL element that represents one embodiment of the present invention, from the viewpoint of improving the efficiency, a phosphorescent material may be used in the light-emitting layer. Metal complexes and the like containing a central metal such as Ir or Pt can be used favorably as the phosphorescent material. Specific examples of Ir complexes include FIr(pic) [iridium(III) bis[(4,6-difluorophenyl)-pyridinato-N,$C^2$]picolinate] which emits blue light, $Ir(ppy)_3$ [fac tris(2-phenylpyridine)iridium] (see the aforementioned M.A. Baldo et al., Nature, vol. 403, page 750 (2000)) which emits green light, and $(btp)_2Ir(acac)$ {bis[2-(2'-benzo[4,5-$\alpha$]thienyl)pyridinato-N,$C^3$]iridium(acetyl acetonate)} (see Adachi et al., Appl. Phys. Lett., 78 No. 11, 2001, page 1622) or $Ir(piq)_3$ [tris(1-phenylisoquinoline)iridium] which emit red light. Sspecific example of a Pt complex include 2,3,7,8,12,13,17,18-octaethyl-21H,23H-porphine platinum (PtOEP) which emits red light. A low-molecular weight material or a dendride such as an iridium core dendrimer can be used as the phosphorescent material. Further, derivatives of these compounds can also be used.

When the light-emitting layer contains a phosphorescent material, the layer preferably also contains a host material in addition to the phosphorescent material. The host material may be a low-molecular weight compound, a polymer, or a dendrimer or the like. Examples of the low-molecular weight compound include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymer include polyvinylcarbazole, polyphenylene, polyfluorene, and derivatives of these polymers.

The light-emitting layer may be formed by a vapor deposition method or a coating method.

When the light-emitting layer is formed by a coating method, the organic EL element can be produced inexpensively, which is particularly desirable. In order to form the light-emitting layer by a coating method, a solution containing a phosphorescent material, and where necessary a host material, may be applied to a desired substrate using a conventional coating method. Examples of the coating method include inkjet methods, casting methods, dipping methods, printing methods such as relief printing, intaglio printing, offset printing, lithographic printing, letterpress inversion offset printing, screen printing and gravure printing, and spin coating methods.

[Cathode]

The cathode material is preferably a metal or metal alloy such as Li, Ca, Mg, Al, In, Cs, Ba, Mg/Ag, LiF or CsF.

[Anode]

A metal (for example, Au) or another material having metal-like conductivity can be used as the anode. Examples of these other materials include oxides (for example, ITO: indium oxide/tin oxide) and conductive polymers (for example, polythiophene-polystyrene sulfonate mixtures (PEDOT:PSS)).

[Hole Injection Layer, Hole Transport Layer]

The organic layer formed using the composition described above is preferably used as at least one of a hole

injection layer and a hole transport layer. In those cases where the organic EL element contains an organic layer formed using the composition described above as a hole injection layer, and also contains a hole transport layer, a conventional material may be used for the hole transport layer. In those cases where the organic EL element contains an organic layer formed using the composition described above as a hole transport layer, and also contains a hole injection layer, a conventional material may be used for the hole injection layer. The organic EL element may have the organic layer as a hole injection and transport layer, or may have two of the organic layers as a hole injection layer and a hole transport layer respectively.

[Electron Transport Layer, Electron Injection Layer]

Examples of the electron transport layer and electron injection layer include phenanthroline derivatives (for example, 2,9-dimethyl-4,7-diphenyl-1,10-phenathroline (BCP)), bipyridine derivatives, nitro-substituted fluorene derivatives, diphenylquinone derivatives, thiopyran dioxide derivatives, condensed ring tetracarboxylic anhydrides of naphthalene and perylene and the like, carbodiimides, fluorenylidene methane derivatives, anthraquinodimethane and anthrone derivatives, oxadiazole derivatives (for example, 2-(4-biphenylyl)-5-(4-tert-butylphenyl-1,3,4-oxadiazole) (PBD)), and aluminum complexes (for example, tris(8-hydroxyquinolinato)aluminum(III) ($Alq_3$) and bis(2-methyl-8-quinolinato)-4-phenylphenolate aluminum(III) (BAlq)). Moreover, thiadiazole derivatives in which the oxygen atom in the oxadiazole ring of an aforementioned oxadiazole derivative has been substituted with a sulfur atom, and quinoxaline derivatives having a quinoxaline ring that is known to function as an electron-withdrawing group, may also be used.

[Substrate]

There are no particular limitations on the types of glass and plastic and the like that can be used as the substrate for the organic EL element. Further, a flexible substrate is preferable, and glass, quartz, and light-transmitting resin films and the like can be used favorably. When a resin film is used, the organic EL element can be imparted with flexibility (namely, a flexible substrate), which is particularly desirable.

Examples of the resin film include films formed from polyethylene terephthalate (PET), polyethylene naphthalate (PEN), polyethersulfone (PES), polyetherimide, polyetheretherketone, polyphenylene sulfide, polyarylate, polyimide, polycarbonate (PC), cellulose triacetate (TAC) and cellulose acetate propionate (CAP).

When a resin film is used, in order to suppress the permeation of water vapor and oxygen and the like, the resin film may be coated with an inorganic substance such as silicon oxide or silicon nitride prior to use.

[Sealing]

The organic EL element that represents an embodiment of the present invention may be sealed using the same method as that described below for a photoelectric conversion element in order to reduce the effects of the external atmosphere and extend the lifespan of the element.

[Emission Color]

There are no particular limitations on the light emission color from the organic EL element, but a white light-emitting element can be used for household illumination, in-vehicle illumination, and in various illumination devices such as clocks or liquid crystal backlights, and is consequently preferred.

Currently, achieving white light emission with a single material is difficult, and therefore the method used for forming a white light-emitting element typically involves using a plurality of light-emitting materials to simultaneously emit a plurality of light colors, and then mixing these colors to obtain a white light emission. There are no particular limitations on the plurality of emission colors that are combined, and examples include combinations that include three maximum emission wavelengths for blue, green and red, and combinations containing two maximum emission wavelengths that utilize a complementary color relationship, such as blue and yellow, or yellow-green and orange. Furthermore, the emission color can be controlled by altering the type and amount of the phosphorescent material.

[Display Element, Illumination Device, Display Device]

A display element that represents one embodiment of the present invention includes the organic EL element described above. For example, by using an aforementioned organic EL element as the element corresponding with each pixel of red, green and blue (RGB), a color display element can be obtained.

Image formation systems include simple matrix systems in which organic EL elements arrayed in a panel are driven directly by an electrode disposed in a matrix arrangement, and active matrix systems in which a thin-film transistor

is provided and driven in each element. The former system has a simple structure, but there is a limit to the number of vertical pixels, and therefore this type of system is typically used for displaying text or the like. The latter system has a low drive voltage, requires minimal current, and yields bright and very detailed images, and is therefore used for high-quality displays.

Further, an illumination device that represents an embodiment of the present invention includes the organic EL element described above. Moreover, a display device that represents another embodiment of the present invention includes the illumination device and a liquid crystal element as a display unit. The display device may be a device that uses the above illumination device as a backlight (white light emission source), and uses a liquid crystal element as the display unit, namely a liquid crystal display device. This configuration is a configuration in which, in a conventional liquid crystal display device, only the backlight has been replaced with the illumination device described above, and, for the liquid crystal element unit, conventional technology can be employed.

[Organic Photoelectric Conversion Element]

Examples of organic photoelectric conversion elements include organic solar cells and organic optical sensors, and these elements typically include a photoelectric conversion layer, electrodes and a substrate. Moreover, for the purpose of improving the conversion efficiency or the stability within air, the element may further include one or more other layers such as a buffer layer or an electron transport layer. The organic photoelectric conversion element includes at least the organic layer described above, wherein the organic layer may be used as the photoelectric conversion layer or a buffer layer, and is preferably used as a buffer layer. Accordingly, one example of the organic photoelectric conversion element has, in sequence, an anode, the organic layer as a buffer layer, a photoelectric conversion layer and a cathode, and may also include one or more other optional layers between these layers. The structure of the organic photoelectric conversion element is described below in further detail.

[Photoelectric Conversion Layer]

Any material that absorbs light, causes a charge separation, and generates an electromotive force can be used for the photoelectric conversion layer. In particular, from the viewpoint of conversion efficiency, a mixture obtained by blending a p-type organic semiconductor and an n-type organic semiconductor is preferred.

Examples of materials that can be used favorably as the p-type organic semiconductor include polymers or oligomers such as oligothiophene, polyalkylthiophene, poly(3-hexylthiophene) (P3HT) and polyphenylene vinylene (PPV); porphyrin, phthalocyanine and copper phthalocyanine; and derivatives of these compounds.

Examples of materials that can be used favorably as the n-type organic semiconductor include -CN group-containing or $-CF_3$ group-containing polymers or oligomers such as CN-poly(phenylene-vinylene) (CN-PPV), MEH-CN-PPV, and $-CF_3$ substituted polymers thereof; polymers or oligomers such as poly(fluorene) derivatives and fluorene-benzothiadiazole copolymers; fullerene ($C_{60}$), [6,6]-phenyl-$C_{61}$-butyric acid methyl ester (PCBM), [6,6]-phenyl-$C_{71}$-butyric acid methyl ester (PCBM), naphthalene tetracarboxylic dianhydride (NTCDA), perylene tetracarboxylic dianhydride (PTCDA), naphthalene tetracarboxylic diimide, perylene tetracarboxylic diimide, quinacridone; and derivatives of these compounds.

There are no particular limitations on the method used for forming the photoelectric conversion layer, and the layer may be formed by a vapor deposition method or a coating method. Formation by a coating method enables the organic photoelectric conversion element to be produced inexpensively, and is therefore preferred. Examples of methods that can be used for forming the photoelectric conversion layer by a coating method include the same formation methods as those mentioned above for forming the light-emitting layer.

[Other Layers]

Further, besides the photoelectric conversion layer, the organic photoelectric conversion element also has a buffer layer as mentioned above, and may also include an electron transport layer or the like. The organic layer described above can be used as the buffer layer, and LiF, TiOx or ZnOx or the like is generally used for the electron transport layer.

[Electrodes]

Any material that exhibits conductivity can be used as the electrodes. Examples of materials for the electrodes include metals such as platinum, gold, silver, aluminum, chromium, nickel, copper, titanium, magnesium, calcium, barium, sodium and lithium fluoride, or alloys or salts of these metals; metal oxides such as indium oxide and tin oxide, or an alloy thereof (ITO); conductive polymers such as polyaniline, polypyrrole, polythiophene and polyacetylene; the above conductive polymers containing an added dopant, including an acid such as hydrochloric acid, sulfuric acid or sulfonic

acid, a Lewis acid such as $FeCl_3$, halogen atoms such as iodine, or metal atoms such as sodium or potassium; and conductive composite materials in which metal particles or conductive particles of carbon black, fullerene or carbon nanotubes or the like are dispersed within a matrix such as a polymer binder. A combination of these materials may also be used.

Further, at least one pair of (two) electrodes is provided, and at least one of the electrodes is a transparent electrode. Examples of the transparent electrode include oxides such as indium tin oxide (ITO), and indium zinc oxide (IZO); metal thin films; and conductive polymers such as PEDOT:PSS.

The electrodes have the function of collecting the holes and electrons generated inside the photoelectric conversion layer, and the use of an electrode material that is suitable for collecting holes and electrons is preferable. Examples of electrode materials that are suitable for collecting holes include materials having a high work function such as Au and ITO. On the other hand, examples of electrodes that are suitable for collecting electrons include materials having a low work function such as Al.

There are no particular limitations on the method used for forming the electrodes, and methods such as vacuum deposition, sputtering and coating methods can be used.

[Substrate]

Any material that is capable of supporting the layers can be used as the substrate. Examples of the material for the substrate include inorganic materials such as glass; organic materials such as polyethylene terephthalate (PET), polyethylene naphthalate (PEN), polyethersulfone (PES), polyimide (PI), polyetherimide (PEI), cycloolefin polymer (COP), polyphenylene sulfide (PPS), nylon, polystyrene, polyethylene, polypropylene, polyvinyl alcohol, fluororesin, vinyl chloride, cellulose, polyvinylidene chloride, aramid, polyurethane, polycarbonate, polyarylate, polynorbornene and polylactic acid; and composite materials including metals such as stainless steel, titanium or aluminum which have been surface-coated or laminated in order to impart insulating properties. Further, in order to impart gas barrier properties, a substrate on which an inorganic substance such as silicon oxide or silicon nitride has been formed may also be used.

In particular, films formed from organic materials such as PET, PEN, PES, PI, PEI, COP and PPS provide good transparency and flexibility, and are consequently preferred.

[Sealing]

The organic photoelectric conversion element that represents one embodiment of the present invention may be sealed in order to reduce the effects of the external atmosphere and extend the lifespan of the element. Examples of materials that may be used for the sealing process include glass, epoxy resins, acrylic resins, plastic films of PET or PEN or the like, and inorganic substances such as silicon oxide and silicon nitride.

There are no particular limitations on the sealing method, and examples of methods that may be used include methods in which the sealing material is formed directly on the organic photoelectric conversion element by vacuum deposition, sputtering, or a coating method or the like, and methods in which a glass or plastic film is bonded to the photoelectric conversion element using an adhesive.

Embodiments of the present invention include those described below. However, the present invention is not limited to the following embodiments.

<1> An organic electronic material containing a polymer or oligomer having a structural unit that has hole transport properties, and also having an alkyl chain of 6 to 20 carbon atoms.

<2> The organic electronic material according to <1>, wherein the structural unit having hole transport properties includes at least one structural unit selected from the group consisting of a structural unit containing an aromatic amine structure, a structural unit containing a carbazole structure, a structural unit containing a thiophene structure, a structural unit containing a fluorene structure, and a structural unit containing a furan structure.

<3> The organic electronic material according to <1> or <2>, wherein the polymer or oligomer has a structure represented by formula (Ia) shown below.

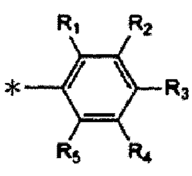

Formula (Ia)

(Each of $R^1$ to $R^5$ in formula (Ia) independently represents a hydrogen atom or an alkyl group, and at least one of $R^1$ to $R^5$ is a linear alkyl group of 6 to 20 carbon atoms.)

<4> The organic electronic material according to any one of <1> to <3>, wherein the structural unit having hole transport properties includes a divalent structural unit having an alkyl chain of 6 to 20 carbon atoms.

<5> The organic electronic material according to any one of <1> to <4>, wherein the polymer or oligomer has an alkyl chain of 8 to 12 carbon atoms.

<6> The organic electronic material according to any one of <1> to <5>, wherein the polymer or oligomer has a branched structure.

<7> The organic electronic material according to <6>, wherein the polymer or oligomer contains a structure unit containing at least one selected from the group consisting of structures represented by general formulas (1) to (10) shown below as a unit that functions as an origin for forming a branched structure.

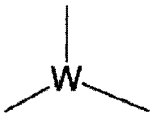

(1)

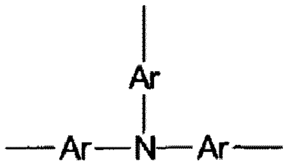

(2)

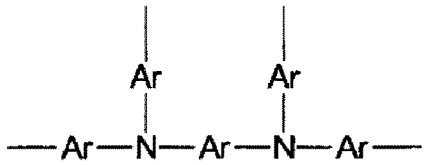

(3)

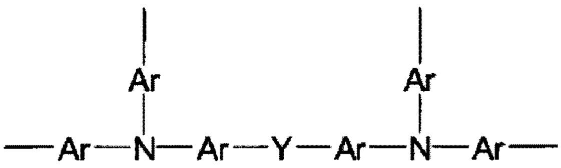

(4)

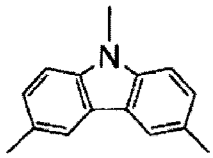

(5)

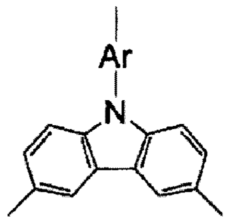

(6)

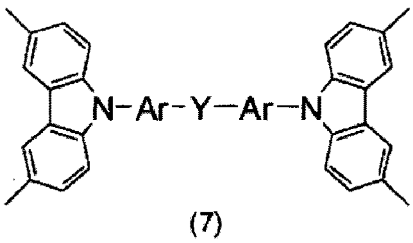

(7)

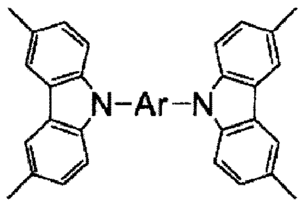

(8)

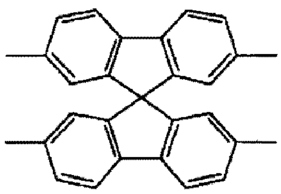

(9)

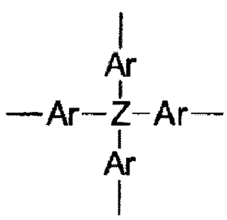

(10)

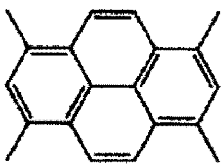

(11)

(In the formulas, each Ar independently represents a divalent linking group, W represents a trivalent linking group, and Y represents a divalent linking group. W, the benzene rings and the Ar groups may each have a substituent. Z represents a carbon atom, a silicon atom or a phosphorus atom.)

<8> The organic electronic material according to any one of <1> to <7>, wherein the polymer or oligomer contains at least one polymerizable functional group.

<9> The organic electronic material according to any one of <1> to <8>, also containing an initiator.

<10> An ink composition containing the organic electronic material according to any one of <1> to <9> and a solvent.

<11> An organic layer formed using the organic electronic material according to any one of <1> to <9>, or the ink composition according to <10>.

<12> An organic electronic element including at least one of the organic layer according to <11>.

<13> An organic electroluminescent element including at least one of the organic layer according to <11>.

<14> The organic electroluminescent element according to <13>, also including a flexible substrate.

<15> The organic electroluminescent element according to <13>, also including a resin film substrate.

<16> A display element including the organic electroluminescent element according to any one of <13> to <15>.

<17> An illumination device including the organic electroluminescent element according to any one of <13> to <15>.

<18> A display device including the illumination device according to <17> and a liquid crystal element as a display unit.

Examples of the embodiments are further described below. Examples of the organic electronic material include organic electronic materials having the alkyl chain of 6 to 20 carbon atoms in a divalent structural unit; organic electronic materials that also contain an initiator, wherein the initiator contains an oxidizing agent; organic electronic materials that also contain an initiator, wherein the initiator contains an onium salt; and organic electronic materials in which the weight average molecular weight of the polymer (A) is within a range from 1,000 to 1,000,000. Further, examples of the organic electronic element include elements having at least two electrodes, and an organic layer positioned between those electrodes; examples of the organic electroluminescent element include elements having an anode, an organic layer, a light-emitting layer, and a cathode; and examples of the organic photoelectric conversion element include elements having an anode, an organic layer, a photoelectric conversion layer, and a cathode.

EXAMPLES

The present invention is described below in further detail using a series of examples, but the present invention is not limited by the following examples. Unless specifically stated otherwise, "%" means "% by mass".

<Preparation of Pd Catalyst>

In a glove box under a nitrogen atmosphere at room temperature, tris(dibenzylideneacetone)dipalladium (73.2 mg, 80 μmol) was weighed into a sample tube, anisole or toluene (15 ml) was added, and the resulting mixture was agitated for 30 minutes. In a similar manner, tris(t-butyl)phosphine (129.6 mg, 640 μmol) was weighed into a sample tube, anisole (5 mL) was added, and the resulting mixture was agitated for 5 minutes. The two solutions were then mixed together and stirred for 30 minutes at room temperature to obtain a catalyst solution (hereafter also referred to as the "prepared Pd catalyst anisole solution"). All the solvents used in the catalyst preparation were deaerated by nitrogen bubbling for at least 30 minutes prior to use.

<Synthesis of Charge Transport Polymer 1>

A three-neck round-bottom flask was charged with an (L) monomer: monomer 1 shown below (5.0 mmol), a (B) monomer: monomer 2 shown below (2.0 mmol), a (T1) monomer: monomer 3 shown below (1.4 mmol), a (T2) monomer: monomer 4 shown below (2.6 mmol) and anisole (20 mL), and the prepared Pd catalyst anisole solution (7.5 mL) was then added. After stirring for 30 minutes, a 10% aqueous solution of tetraethylammonium hydroxide (20 mL) was added. The resulting mixture was heated and refluxed for 2 hours. All the operations up to this point were conducted under a stream of nitrogen. Further, all of the solvents were deaerated by nitrogen bubbling for at least 30 minutes prior to use. In the formula for monomer 1 shown below, $-C_8H_{17}$ represents an n-octyl group (a linear alkyl group of 8 carbon atoms).

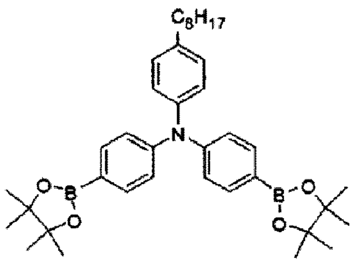

Monomer 1

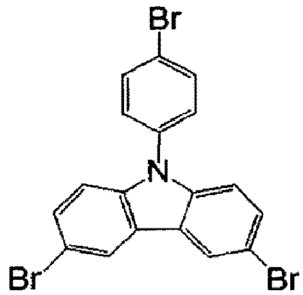

Monomer 2

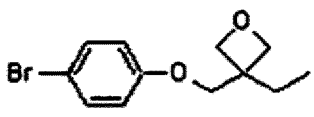

Monomer 3

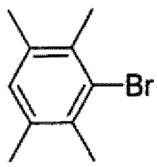

Monomer 4

After completion of the reaction, the organic layer was washed with water, and the organic layer was then poured into methanol-water (9:1). The resulting precipitate was collected by filtration, and washed with methanol-water (9:1). The resulting precipitate was collected by filtration and dried under vacuum, and subsequently stirred for 30 minutes at 60°C in a butyl acetate-toluene (1:1) mixed solution (using 50 mL of solution per 1.5 g of the precipitate), and a hot filtration was then performed to remove low-molecular weight components from the polymer. The same operation was repeated three times, and the polymer was then thoroughly dried and then dissolved in toluene to obtain a 10% polymer solution. A scavenger ("Triphenylphosphine, polymer-bound on styrene-divinylbenzene copolymer", manufactured by Strem Chemicals Inc.) was added to the solution in a mass equal to the mass of the polymer, and the resulting mixture was stirred under reflux for at least one hour. Subsequently, the scavenger was removed by filtration through a polytetrafluoroethylene filter having a pore size of 0.2 μm (DISMIC 25JP020AN), and the filtrate was mixed with methanol to re-precipitate the polymer. The polymer was collected by filtration and dried under vacuum in a desiccator to obtain a charge transport polymer 1.

With the exception of altering the blend ratio between the monomers used in the synthesis to the ratios shown below in Table 1, a charge transport polymer 2, a charge transport polymer 3 and a charge transport polymer 4 were synthesized in the same manner as the charge transport polymer 1.

Table 1]

| Table 1 | (L) monomer | (B) monomer | (T1) monomer | (T2) monomer | Blend ratio L:B:T1:T2 |
|---|---|---|---|---|---|
| Charge transport polymer 1 | Monomer 1 | Monomer 2 | Monomer 3 | Monomer 4 | 5:2:1.4:2.6 |
| Charge transport polymer 2 | Monomer 1 | Monomer 2 | Monomer 3 | Monomer 4 | 5:2:1.0:3.0 |
| Charge transport polymer 3 | Monomer 1 | Monomer 2 | Monomer 3 | Monomer 4 | 5:2:0.6:3.4 |
| Charge transport polymer 4 | Monomer 1 | Monomer 2 | Monomer 3 | Monomer 4 | 5:2:0.2:3.8 |

<Synthesis of Charge Transport Polymer 5>

A three-neck round-bottom flask was charged with an (L1) monomer: monomer 1 (2.5 mmol), an (L2) monomer: monomer 5 shown below (2.5 mmol), a (B) monomer: monomer 2 (2.0 mmol), a (T1) monomer: monomer 3 shown below (1.4 mmol), a (T2) monomer: monomer 4 shown below (2.6 mmol) and anisole (20 mL), and the prepared Pd catalyst anisole solution (7.5 mL) was then added. After stirring for 30 minutes, a 10% aqueous solution of tetraethylammonium

hydroxide (20 mL) was added. The resulting mixture was heated and refluxed for 2 hours. All the operations up to this point were conducted under a stream of nitrogen. Further, all of the solvents were deaerated by nitrogen bubbling for at least 30 minutes prior to use. Thereafter, purification treatments were performed in the same manner as those described above for the charge transport polymer 1, thus obtaining a charge transport polymer 5. In the formula for monomer 5 shown below, $-C_4H_9$ represents an n-butyl group (a linear alkyl group of 4 carbon atoms).

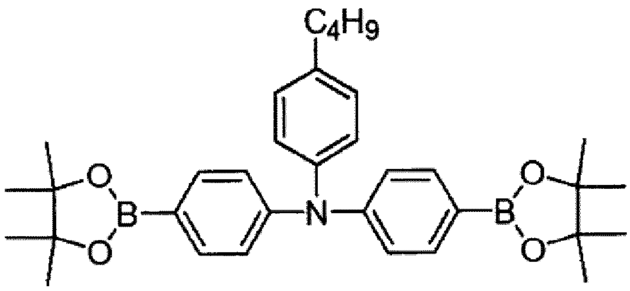

Monomer 5

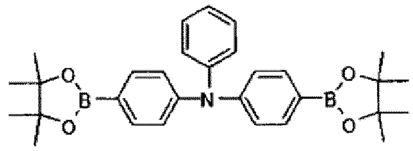

Monomer 6

With the exceptions of altering the monomers used in the synthesis and altering the blend ratio between the monomers as shown below in Table 2, a charge transport polymer 6, a charge transport polymer 7, a charge transport polymer 8, a charge transport polymer 9, and a charge transport polymer 10 were synthesized in the same manner as the charge transport polymer 5.

[Table 2]

| Table 2 | (L1) monomer | (L2) monomer | (B) monomer | (T1) monomer | (T2) monomer | Blend ratio L1:L2: B:T1:T2 |
|---|---|---|---|---|---|---|
| Charge transport polymer 5 | Monomer 1 | Monomer 5 | Monomer 2 | Monomer 3 | Monomer 4 | 2.5:2.5:2:1.4:2.6 |
| Charge transport polymer 6 | Monomer 1 | Monomer 5 | Monomer 2 | Monomer 3 | Monomer 4 | 2.5:2.5:2:1.0:3.0 |
| Charge transport polymer 7 | Monomer 1 | Monomer 5 | Monomer 2 | Monomer 3 | Monomer 4 | 2.5:2.5:2:0.6:3.4 |
| Charge transport polymer 8 | Monomer 1 | Monomer 6 | Monomer 2 | Monomer 3 | Monomer 4 | 2.5:2.5:2:1.4:2.6 |
| Charge transport polymer 9 | Monomer 1 | Monomer 6 | Monomer 2 | Monomer 3 | Monomer 4 | 2.5:2.5:2:1.0:3.0 |
| Charge transport polymer 10 | Monomer 1 | Monomer 6 | Monomer 2 | Monomer 3 | Monomer 4 | 3.24:1.75:2:0.6: 3.4 |

<Synthesis of Charge Transport Polymer 11>

A three-neck round-bottom flask was charged with an (L) monomer: monomer 5 shown below (5.0 mmol), a (B) monomer: monomer 2 shown below (2.0 mmol), a (T1) monomer: monomer 3 shown below (2.0 mmol), a (T2) monomer: monomer 4 shown below (2.0 mmol) and anisole (20 mL), and the prepared Pd catalyst anisole solution (7.5 mL) was then added. After stirring for 30 minutes, a 10% aqueous solution of tetraethylammonium hydroxide (20 mL) was added. The resulting mixture was heated and refluxed for 2 hours. All the operations up to this point were conducted under a stream of nitrogen. Further, all of the solvents were deaerated by nitrogen bubbling for at least 30 minutes prior

to use. Thereafter, purification treatments were performed in the same manner as those described above for the charge transport polymer 1, thus obtaining a charge transport polymer 13.

With the exception of altering the blend ratio between the monomers used in the synthesis to the ratios shown below in Table 3, a charge transport polymer 12 and a charge transport polymer 13 were synthesized in the same manner as the charge transport polymer 11.

[Table 3]

| Table 3 | (L) monomer | (B) monomer | (T1) monomer | (T2) monomer | Blend ratio L:B:T1:T2 |
|---|---|---|---|---|---|
| Charge transport polymer 11 | Monomer 5 | Monomer 2 | Monomer 3 | Monomer 4 | 5:2:2.0:2.0 |
| Charge transport polymer 12 | Monomer 5 | Monomer 2 | Monomer 3 | Monomer 4 | 5:2:1.4:2.6 |
| Charge transport polymer 13 | Monomer 5 | Monomer 2 | Monomer 3 | Monomer 4 | 5:2:1.0:3.0 |

<Synthesis of Charge Transport Polymer 14>

A three-neck round-bottom flask was charged with an (L) monomer: monomer 5 shown below (5.0 mmol), a (B) monomer: monomer 7 shown below (2.0 mmol), a (T) monomer: monomer 8 shown below (4.0 mmol) and toluene (20 mL), and the prepared Pd catalyst toluene solution (7.5 mL) was then added. After stirring for 30 minutes, a 3M aqueous solution of potassium hydroxide (10 mL) was added. The resulting mixture was heated and refluxed for 2 hours. All the operations up to this point were conducted under a stream of nitrogen. Further, all of the solvents were deaerated by nitrogen bubbling for at least 30 minutes prior to use. Thereafter, purification treatments were performed in the same manner as those described above for the charge transport polymer 1, thus obtaining a charge transport polymer 13. The monomers used in the synthesis and the monomer blend ratio were different, and are therefore shown below in Table 4.

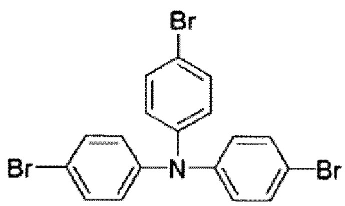

Monomer 7

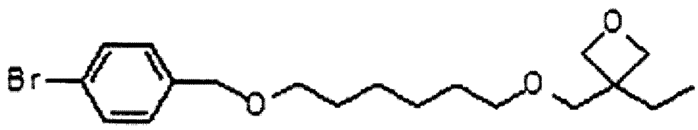

Monomer 8

[Table 4]

| Table 4 | (L) monomer | (B) monomer | (T) monomer | Blend ratio L:B:T |
|---|---|---|---|---|
| Charge transport polymer 14 | Monomer 5 | Monomer 7 | Monomer 8 | 5:2:4 |

The GPC measurement conditions were as follows.
Apparatus: High-performance liquid chromatograph "Prominence", manufactured by Shimadzu Corporation
Feed pump (LC-20AD)
Degassing unit (DGU-20A)
Autosampler (SIL-20AHT)
Column oven (CTO-20A)
PDA detector (SPD-M20A)
Refractive index detector (RID-20A)

Columns:

Gelpack (a registered trademark)
GL-A160S (product number: 686-1J27)
GL-A150S (product number: 685-1J27) manufactured by Hitachi Chemical Co., Ltd.
Eluent: Tetrahydrofuran (THF) (for HPLC, contains stabilizers), manufactured by Wako Pure Chemical Industries, Ltd.

Flow rate: 1 mL/min
Column temperature: 40°C
Detection wavelength: 254 nm
Molecular weight standards: PStQuick A/B/C, manufactured by Tosoh Corporation

The elution time for a polymer with a molecular weight of 20,000 can be determined using a calibration curve prepared from the elution times for polystyrene standard samples having known molecular weights.

The weight average molecular weight, the number average molecular weight, and the proportion (GPC chart area ratio) of low-molecular weight components for each of the obtained polymers were determined by GPC measurements. The GPC measurement conditions were as described above. The obtained values are shown in Table 5.

<Low-Molecular Weight Components>

First is a description of the method used for determining the component proportion of low-molecular weight components in the charge transport polymer using GPC (gel permeation chromatography). "Components having a molecular weight of less than 20,000 (namely, low-molecular weight components) in the molecular weight distribution chart measured by GPC" are deemed the low-molecular weight fraction, and are specified by a polystyrene-equivalent molecular weight described below. The total chart area is the total area beneath all of the peaks excluding solvent and impurity peaks.

[Table 5]

| Table 5 | Weight average molecular weight | Number average molecular weight | Low-molecular weight fraction (%) |
|---|---|---|---|
| Charge transport polymer 1 | 65,789 | 32,423 | 21.0 |
| Charge transport polymer 2 | 193,284 | 55,430 | 9.9 |
| Charge transport polymer 3 | 238,970 | 42,693 | 12.9 |
| Charge transport polymer 4 | 251,065 | 44,168 | 12.3 |
| Charge transport polymer 5 | 301,391 | 52,171 | 12.4 |
| Charge transport polymer 6 | 217,264 | 49,960 | 13.3 |
| Charge transport polymer 7 | 198,428 | 51,050 | 12.7 |
| Charge transport polymer 8 | 136,138 | 48,491 | 11.7 |
| Charge transport polymer 9 | 197,583 | 53,618 | 10.5 |
| Charge transport polymer 10 | 211,744 | 56,172 | 9.7 |

(continued)

| Table 5 | Weight average molecular weight | Number average molecular weight | Low-molecular weight fraction (%) |
|---|---|---|---|
| Charge transport polymer 11 | 138,285 | 34,485 | 15.6 |
| Charge transport polymer 12 | 163,024 | 42,751 | 12.1 |
| Charge transport polymer 13 | 29,700 | 12,000 | 48.3 |
| Charge transport polymer 14 | 46,100 | 14,700 | 30.5 |

<Evaluations of Organic Layer Formation and Residual Film Ratio>

[Example 1]

A coating solution obtained by mixing a solution prepared by dissolving the charge transport polymer 1 (10 mg) in 1,100 μL of toluene and a solution prepared by dissolving an ionic compound 1 (1 mg) represented by a chemical formula shown below as an initiator in 50 μL of toluene was spin coated at 3,000 rpm onto a quartz plate. Subsequently, heating was performed at 200°C for 10 minutes on a hot plate to cause a polymerization reaction. Following heating, the quartz plate was washed by immersion in toluene solvent for 10 seconds.

Ionic compound 1

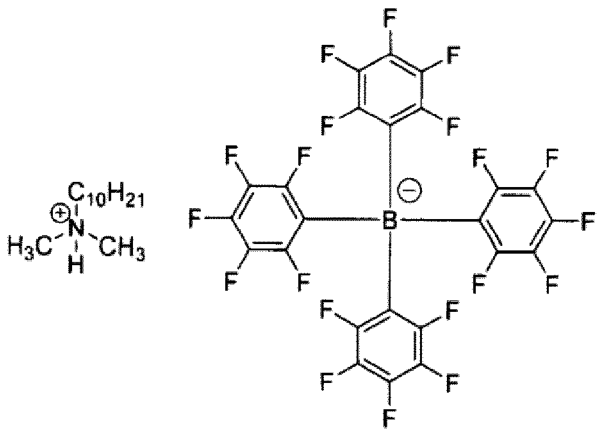

The UV-VIS (ultraviolet-visible) spectrum was measured before and after the washing by immersion in toluene solvent, and the residual film ratio was calculated from the ratio between the absorbances (Abs) at the absorption maxima (λmax) in the obtained spectra.
Before washing: λmax = 358 nm, Abs = 0.429
After washing: λmax = 358 nm, Abs = 0.445

$$\text{Residual film ratio (\%)} = \text{Abs after washing/Abs before washing} \times 100$$
$$= (0.445/0.429) \times 100 = 103.7$$

Measurements of the UV-VIS spectra were performed under the following conditions.
Apparatus: U-3900H spectrophotometer (Hitachi High-Technologies Corporation)

Slit: 2 nm
Scan speed: 600 nm/min
Start wavelength: 500 nm
End wavelength: 250 nm
Reference: quartz substrate

[Examples 2 to 10, Comparative Examples 1 to 3]

With the exception of using one of the charge transport polymers shown below in Table 2 instead of the charge transport polymer 1, an organic layer was formed and the residual film ratio of that organic layer was measured in the same manner as that described above for Example 1. The results are shown in Table 6.

[Table 6]

| Table 6 | Polymer used | Residual film ratio (%) | Proportion of monomer 3 in (T) monomer (%) | Proportion of monomer 1 in (L) monomer (%) |
|---|---|---|---|---|
| Example 1 | Charge transport polymer 1 | 103.7 | 35 | 100 |
| Example 2 | Charge transport polymer 2 | 91.7 | 25 | 100 |
| Example 3 | Charge transport polymer 3 | 84.7 | 15 | 100 |
| Example 4 | Charge transport polymer 4 | 42.6 | 5 | 100 |
| Example 5 | Charge transport polymer 5 | 100.9 | 35 | 50 |
| Example 6 | Charge transport polymer 6 | 84.4 | 25 | 50 |
| Example 7 | Charge transport polymer 7 | 73.1 | 15 | 50 |
| Example 8 | Charge transport polymer 8 | 89.5 | 35 | 50 |
| Example 9 | Charge transport polymer 9 | 84.2 | 25 | 50 |
| Example 10 | Charge transport polymer 10 | 71.0 | 15 | 65 |
| Comparative Example 1 | Charge transport polymer 11 | 91.8 | 50 | 0 |
| Comparative Example 2 | Charge transport polymer 12 | 80.6 | 35 | 0 |

(continued)

| Table 6 | Polymer used | Residual film ratio (%) | Proportion of monomer 3 in (T) monomer (%) | Proportion of monomer 1 in (L) monomer (%) |
|---|---|---|---|---|
| Comparative Example 3 | Charge transport polymer 13 | 18.2 | 25 | 0 |

Based on the results in Table 6, comparison of each of Examples 1 and 5 with Comparative Example 2, and comparison of each of Examples 2 and 6 with Comparative Example 3 reveal that regardless of the fact that the proportion of the monomer 3 having a polymerizable functional group within the (T) monomer was the same in each case, Examples 1 and 5 and Examples 2 and 6 in which the monomer 1 having an alkyl chain of 8 carbon atoms was included in the (L) monomer exhibited higher values for the residual film ratio. Further, comparison of Example 2 and Example 6, and comparison of Example 3 and Example 7 reveal that a larger proportion of the monomer 1 within the (L) monomer yielded superior solvent resistance.

In this manner, in the examples, although the blend amount of the polymerizable functional group was the same, the inclusion of an alkyl chain of 6 to 20 carbon atoms enabled an improvement in solvent resistance to be achieved.

[Example 11]

A coating solution obtained by mixing a solution prepared by dissolving the charge transport polymer 1(10 mg) in 1,100 μL of toluene and a solution prepared by dissolving the above ionic compound 1 (1 mg) in 50 μL of toluene was spin coated at 3,000 rpm onto a quartz plate. Subsequently, heating was performed at 230°C for 10 minutes on a hot plate to cause a polymerization reaction. Following heating, the quartz plate was washed by immersion in toluene solvent for 10 seconds.

The UV-VIS (ultraviolet-visible) spectrum was measured before and after the washing by immersion in toluene solvent, and the residual film ratio was calculated from the ratio between the absorbances (Abs) at the absorption maxima (λmax) in the obtained spectra.
Before washing: λmax = 357 nm, Abs = 0.313
After washing: λmax = 355 nm, Abs = 0.316

$$\text{Residual film ratio (\%)} = \text{Abs after washing/Abs before washing} \times 100$$
$$= (0.316/0.313) \times 100 = 101.0$$

Measurements of the UV-VIS spectra were performed under the following conditions.
Apparatus: U-3900H spectrophotometer (Hitachi High-Technologies Corporation)
Slit: 2 nm
Scan speed: 600 nm/min
Start wavelength: 500 nm
End wavelength: 250 nm
Reference: quartz substrate

[Examples 12 to 20, Comparative Examples 4 to 6]

With the exception of using one of the charge transport polymers shown below in Table 3 instead of the charge transport polymer 1, an organic layer was formed and the residual film ratio of that organic layer was measured in the same manner as that described above for Example 11. The results are shown in Table 7.

[Table 7]

| Table 7 | Polymer used | Residual film ratio (%) | Proportion of monomer 3 in (T) monomer (%) | Proportion of monomer 1 in (L) monomer (%) |
|---|---|---|---|---|
| Example 11 | Charge transport polymer 1 | 101.0 | 35 | 100 |

(continued)

| Table 7 | Polymer used | Residual film ratio (%) | Proportion of monomer 3 in (T) monomer (%) | Proportion of monomer 1 in (L) monomer (%) |
|---|---|---|---|---|
| Example 12 | Charge transport polymer 2 | 99.7 | 25 | 100 |
| Example 13 | Charge transport polymer 3 | 101.5 | 15 | 100 |
| Example 14 | Charge transport polymer 4 | 94.1 | 5 | 100 |
| Example 15 | Charge transport polymer 5 | 100.9 | 35 | 50 |
| Example 16 | Charge transport polymer 6 | 97.0 | 25 | 50 |
| Example 17 | Charge transport polymer 7 | 91.7 | 15 | 50 |
| Example 18 | Charge transport polymer 8 | 97.9 | 35 | 50 |
| Example 19 | Charge transport polymer 9 | 99.5 | 25 | 50 |
| Example 20 | Charge transport polymer 10 | 98.2 | 15 | 65 |
| Comparative Example 4 | Charge transport polymer 11 | 100.2 | 50 | 0 |
| Comparative Example 5 | Charge transport polymer 12 | 96.2 | 35 | 0 |
| Comparative Example 6 | Charge transport polymer 13 | 72.2 | 25 | 0 |

Based on Table 7, as indicated by the results for Comparative Examples 4 to 6, in the comparative examples which did not use the monomer 1, in order to achieve a residual film ratio of 96.2% or greater, the blend amount of the monomer 3 having a polymerizable functional group within the (T) monomer needed to be 35 mol%. In Example 14, despite the fact that the proportion of the monomer 3 having a polymerizable functional group within the (T) monomer was a small value of 5 mol%, a residual film ratio of 94.1% was able to be achieved. In this manner, in the examples, even when the blend amount of the polymerizable functional group was reduced, superior solvent resistance was able to be obtained.

<Production of Organic EL Elements>

[Example 3-1]

The charge transport polymer 14 was applied by spin coating at a revolution rate of 3,000 $min^{-1}$ to a glass substrate on which ITO had been patterned with a width of 1.6 mm, and the applied coating was then dried by heating on a hot plate in the open air at 200°C for 10 minutes, thus forming a hole injection layer (40 nm). The subsequent experiments were all performed under a dry nitrogen atmosphere.

The charge transport polymer 1 (4.5 mg), the ionic compound 1 described above (0.13 mg) and toluene (1.2 mL) were mixed together to prepare an ink composition for forming a hole transport layer. This ink composition was applied by spin coating at a revolution rate of 3,000 $min^{-1}$ to the hole injection layer obtained above, and was then cured by heating on a hot plate at 230°C for 10 minutes, thus forming a hole transport layer (40 nm).

The thus obtained glass substrate was transferred into a vacuum deposition apparatus, and layers of CBP:$Ir(ppy)_3$ (94:6, 30 nm), BAlq (10 nm), $Alq_3$ (30 nm), LiF (0.8 nm) and Al (100 nm) were deposited in that order on top of the hole transport layer, thus forming a light-emitting layer, a hole blocking layer, an electron transport layer, an electron injection layer and a cathode respectively.

Following formation of the electrode, the glass substrate having multiple layers was transferred under a dry nitrogen atmosphere without exposure to the external atmosphere, and was bonded, using a photocurable epoxy resin, to a sealing glass having a countersink of 0.4 mm formed in an alkali-free glass with a thickness of 0.7 mm, thus completing production of a polymer type organic EL element having a multilayer structure.

[Examples 3-2 to 3-9, Comparative Example 3-1]

With the exception of forming the hole transport layer using one of the polymers shown in Table 8 instead of the charge transport polymer 1, organic EL elements were produced in the same manner as Example 3-1.

[Table 8]

| Table 8 | Polymer used |
|---|---|
| Example 3-1 | Charge transport polymer 1 |
| Example 3-2 | Charge transport polymer 2 |
| Example 3-3 | Charge transport polymer 3 |
| Example 3-4 | Charge transport polymer 4 |
| Example 3-5 | Charge transport polymer 6 |
| Example 3-6 | Charge transport polymer 7 |
| Example 3-7 | Charge transport polymer 8 |
| Example 3-8 | Charge transport polymer 9 |
| Example 3-9 | Charge transport polymer 10 |
| Comparative Example 3-1 | Charge transport polymer 12 |

A voltage was applied to each of the organic EL elements obtained in Examples 3-1 to 3-9 and Comparative Example 3-1, and the light emission performance was evaluated. The results confirmed a green light emission from each element. For each element, the drive voltage and emission efficiency when the emission luminance was 5,000 $cd/m^2$, and the emission lifespan (luminance half-life) when the initial luminance was 1,000 $cd/m^2$ or 5,000 $cd/m^2$ were measured. The measurement results are shown in Table 9.

[Table 9]

| Table 9 | Polymer used | Drive voltage (V) | Emission efficiency (cd/A) | Emission lifespan (h) | Luminance when measuring lifespan | Proportion of monomer 3 in (T) monomer (%) | Proportion of monomer 1 in (L) monomer (%) |
|---|---|---|---|---|---|---|---|
| Example 3-1 | Charge transport polymer 1 | 8.57 | 26.0 | 53.3 | 5000 | 35 | 100 |
| Example 3-2 | Charge transport polymer 2 | 8.27 | 25.1 | 59.0 | 5000 | 25 | 100 |
| Example 3-3 | Charge transport polymer 3 | 8.33 | 25.9 | 68.6 | 5000 | 15 | 100 |
| Example 3-4 | Charge transport polymer 4 | 8.12 | 25.2 | 76.6 | 5000 | 5 | 100 |
| Comparative Example 3-1 | Charge transport polymer 12 | 8.57 | 22.9 | 39.7 | 5000 | 35 | 0 |
| Example 3-5 | Charge transport polymer 6 | 6.38 | 24.5 | 85.6 | 1000 | 25 | 50 |
| Example 3-6 | Charge transport polymer 7 | 6.23 | 23.5 | 99.0 | 1000 | 15 | 50 |
| Example 3-7 | Charge transport polymer 8 | 6.54 | 23.4 | 69.2 | 1000 | 35 | 50 |
| Example 3-8 | Charge transport polymer 9 | 6.84 | 24.8 | 112.6 | 1000 | 25 | 50 |
| Example 3-9 | Charge transport polymer 10 | 6.63 | 23.1 | 113.1 | 1000 | 15 | 65 |

As is evident from Table 9, the organic EL elements of Examples 3-1 to 3-4 each exhibited a drive voltage similar to, or lower than, that of Comparative Example 3-1, and also exhibited superior emission efficiency and a longer emission lifespan than Comparative Example 3-1.

Further, comparison of Example 3-5 and Example 3-6, and comparison of Example 3-7 and Example 3-8 reveal that a smaller proportion of the monomer 3 having a polymerizable functional group within the (T) monomer yielded a longer emission lifespan. In other words, by using the monomer 1, the proportion of the monomer 3 within the (T) monomer was able to be successfully reduced while maintaining satisfactory solvent resistance, and by using such charge transport polymers, the remarkable effects of improved emission efficiency and improved emission lifespan were able to be achieved.

DESCRIPTION OF THE REFERENCE SIGNS

1: Light-emitting layer
2: Anode
3: Hole injection layer
4: Cathode
5: Electron injection layer
6: Hole transport layer
7: Electron transport layer
8: Substrate

## Claims

1. An organic electronic material comprising a polymer or oligomer having a structural unit that has hole transport properties, and also having an alkyl chain of 6 to 20 carbon atoms.

2. The organic electronic material according to Claim 1, wherein the structural unit having hole transport properties includes at least one structural unit selected from the group consisting of a structural unit containing an aromatic amine structure, a structural unit containing a carbazole structure, a structural unit containing a thiophene structure, a structural unit containing a fluorene structure, and a structural unit containing a furan structure.

3. The organic electronic material according to Claim 1 or 2 wherein the polymer or oligomer has a structure represented by formula (Ia) shown below:

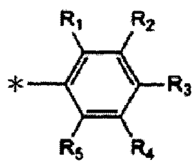

Formula (Ia)

wherein each of $R^1$ to $R^5$ in formula (Ia) independently represents a hydrogen atom or an alkyl group, and at least one of $R^1$ to $R^5$ is a linear alkyl group of 6 to 20 carbon atoms.

4. The organic electronic material according to any one of Claims 1 to 3, wherein the structural unit having hole transport properties includes a divalent structural unit having an alkyl chain of 6 to 20 carbon atoms.

5. The organic electronic material according to any one of Claims 1 to 4, wherein the polymer or oligomer has an alkyl chain of 8 to 12 carbon atoms.

6. The organic electronic material according to any one of Claims 1 to 5, wherein the polymer or oligomer has a branched structure.

7. The organic electronic material according to Claim 6, wherein the polymer or oligomer comprises a structural unit including at least one selected from the group consisting of structures represented by general formulas (1) to (10) shown below as a unit that functions as an origin for forming a branched structure:

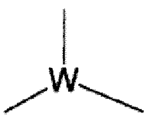

(1)

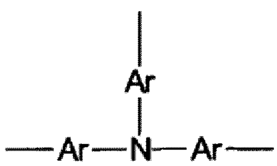

(2)

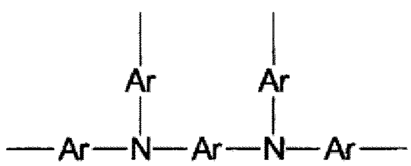

(3)

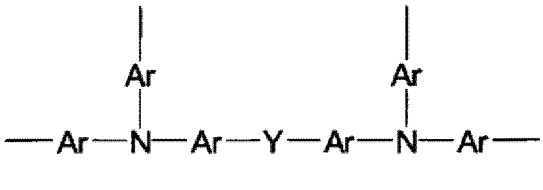

(4)

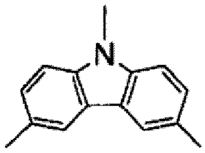

(5)

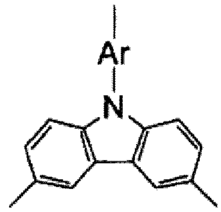

(6)

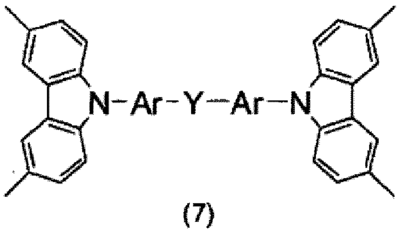

(7)

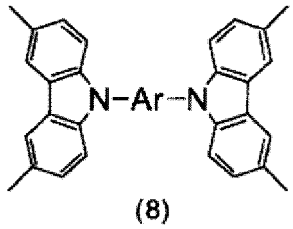

(8)

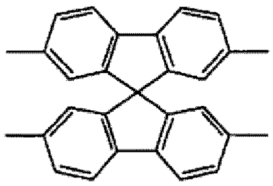

(9)

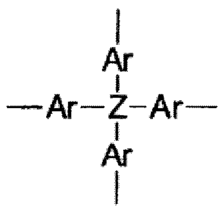

(10)

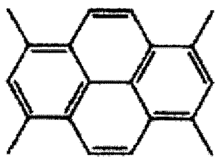

(11)

wherein, in the formulae, each Ar independently represents a divalent linking group, W represents a trivalent linking group, Y represents a divalent linking group, W, a benzene ring and Ar may each have a substituent, and Z represents a carbon atom, a silicon atom or a phosphorus atom.

**8.** The organic electronic material according to any one of Claims 1 to 7, wherein the polymer or oligomer comprises at least one polymerizable functional group.

**9.** The organic electronic material according to any one of Claims 1 to 8, further comprising an initiator.

**10.** An ink composition comprising the organic electronic material according to any one of Claims 1 to 9 and a solvent.

**11.** An organic layer formed using the organic electronic material according to any one of Claims 1 to 9, or the ink composition according to Claim 10.

**12.** An organic electronic element comprising at least one of the organic layer according to Claim 11.

**13.** An organic electroluminescent element comprising at least one of the organic layer according to Claim 11.

**14.** The organic electroluminescent element according to Claim 13, further comprising a flexible substrate.

**15.** The organic electroluminescent element according to Claim 13, further comprising a resin film substrate.

**16.** A display element comprising the organic electroluminescent element according to any one of Claims 13 to 15.

**17.** An illumination device comprising the organic electroluminescent element according to any one of Claims 13 to 15.

**18.** A display device comprising the illumination device according to Claim 17, and a liquid crystal element as a display unit.

FIG.1

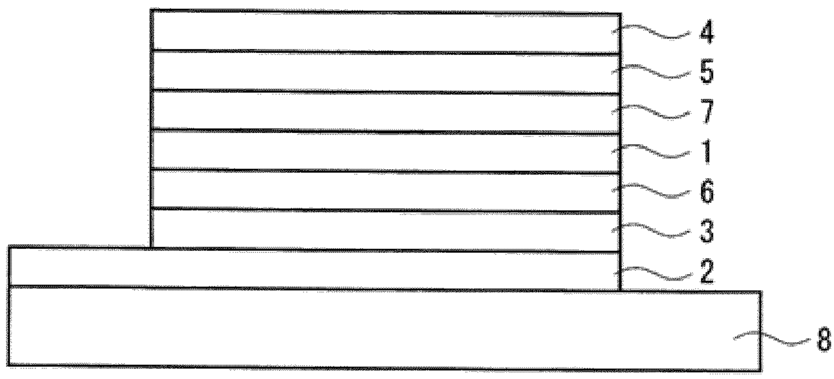

**INTERNATIONAL SEARCH REPORT**

International application No. PCT/JP2017/012068

A. CLASSIFICATION OF SUBJECT MATTER
*H01L51/50*(2006.01)i, *C08G61/12*(2006.01)i, *C09D11/00*(2014.01)i, *G09F9/30*(2006.01)i, *H01L27/32*(2006.01)i

According to International Patent Classification (IPC) or to both national classification and IPC

B. FIELDS SEARCHED

Minimum documentation searched (classification system followed by classification symbols)
H01L51/50, C08G61/12, C09D11/00, G09F9/30, H01L27/32

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | WO 2015/122464 A1 (Hitachi Chemical Co., Ltd.), 20 August 2015 (20.08.2015), claims 1 to 17; paragraphs [0049] to [0051], [0109], [0117] to [0118], [0126], [0137]; paragraph [0181], table 7, examples 6 to 10; paragraph [0193], table 10, examples 11 to 12 & US 2017/0044308 A1 claims 1 to 19; paragraphs [0057] to [0063], [0124], [0133] to [0135], [0177] to [0178]; paragraph [0203], table 7; paragraph [0213], table 10 & EP 3106485 A1 & CN 105992786 A & KR 10-2016-0123298 A & TW 201546108 A | 1-18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 June 2017 (08.06.17) | 20 June 2017 (20.06.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/012068

C (Continuation). DOCUMENTS CONSIDERED TO BE RELEVANT

| Category* | Citation of document, with indication, where appropriate, of the relevant passages | Relevant to claim No. |
|---|---|---|
| X | JP 2015-113410 A (Samsung Electronics Co., Ltd.), 22 June 2015 (22.06.2015), claims 1 to 17; paragraphs [0087] to [0088]; paragraph [0118], polymer compound 10 (Family: none) | 1-5,8,10-18 |
| X | WO 2013/146806 A1 (Sumitomo Chemical Co., Ltd.), 03 October 2013 (03.10.2013), claims 1 to 23; paragraph [0679], table 4, polymer compounds 1 to 23 & US 2015/0115204 A1 claims 1 to 23; paragraph [0633], table 4, polymer compounds 1 to 23 & EP 2832761 A1 & CN 104321362 A & KR 10-2014-0148424 A & TW 201345947 A | 1-5,8 |
| X | JP 2011-506626 A (E.I. Du Pont de Nemours & Co.), 03 March 2011 (03.03.2011), paragraphs [0172] to [0175], compound U & WO 2009/067419 A1 page 56, example 4, compound u & US 2011/0095269 A1 & US 2012/0013245 A1 & US 2012/0065432 A1 & US 2013/0193423 A1 & EP 2217674 A1 & KR 10-2010-0098533 A & TW 200940481 A | 1-2,4-5,8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010140553 A


### Non-patent literature cited in the description


- **T. YAMAMOTO et al.** *Bull. Chem. Soc. Jpn.,* 1978, vol. 51 (7), 2091
- **M. ZEMBAYASHI et al.** *Tet. Lett.,* 1977, vol. 47, 4089
- **A. SUZUKI.** *Synthetic Communications,* 1981, vol. 11 (7), 513
- **M.A. BALDO et al.** *Nature,* 1998, vol. 395, 151
- **M.A. BALDO et al.** *Applied Physics Letters,* 1999, vol. 75, 4
- **M.A. BALDO et al.** *Nature,* 2000, vol. 403, 750
- **ADACHI et al.** *Appl. Phys. Lett.,* 2001, vol. 78 (11), 1622